(19) Europäisches Patentamt
European Patent Office
Office européen des brevets

(11) EP 4 269 120 B1

(12) EUROPEAN PATENT SPECIFICATION

(45) Date of publication and mention of the grant of the patent:
**24.06.2026 Bulletin 2026/26**

(21) Application number: **21910850.3**

(22) Date of filing: **22.12.2021**

(51) International Patent Classification (IPC):
***B41N 1/08*** *(2006.01)* ***B41N 3/03*** *(2006.01)*
***C25D 11/16*** *(2006.01)* ***C25D 11/24*** *(2006.01)*
*B41C 1/10* *(2006.01)* *B41F 7/24* *(2006.01)*

(52) Cooperative Patent Classification (CPC):
**B41N 1/083; B41N 3/034; C25D 11/16; C25D 11/24;** B41C 1/1008; B41C 1/1016; B41C 2210/08; B41F 7/24

(86) International application number:
**PCT/JP2021/047540**

(87) International publication number:
**WO 2022/138710 (30.06.2022 Gazette 2022/26)**

(54) **LITHOGRAPHIC PRINTING PLATE PRECURSOR, METHOD OF PRODUCING A LITHOGRAPHIC PRINTING PLATE AND PRINTING METHOD**

FLACHDRUCKPLATTENVORLÄUFER, VERFAHREN ZUR HERSTELLUNG EINER FLACHDRUCKPLATTE UND DRUCKVERFAHREN

PRÉCURSEUR DE PLAQUE D’IMPRESSION LITHOGRAPHIQUE, PROCÉDÉ DE FABRICATION DE PLAQUE D’IMPRESSION LITHOGRAPHIQUE ET PROCÉDÉ D’IMPRESSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.12.2020 JP 2020217799**
**31.03.2021 JP 2021060269**

(43) Date of publication of application:
**01.11.2023 Bulletin 2023/44**

(73) Proprietor: **FUJIFILM Corporation**
**Tokyo 106-8620 (JP)**

(72) Inventors:
- **MATSUURA Atsushi**
**Haibara-gun, Shizuoka 421-0396 (JP)**
- **KOZAWA Yusuke**
**Haibara-gun, Shizuoka 421-0396 (JP)**
- **ARIMURA Keisuke**
**Haibara-gun, Shizuoka 421-0396 (JP)**

(74) Representative: **HGF**
**HGF Limited**
**4th Floor, 1 City Square**
**Leeds LS1 2ES (GB)**

(56) References cited:
**EP-A2- 1 577 115**
**WO-A1-2019/087516**
**WO-A1-2019/087516**
**JP-A- 2005 088 300**
**JP-A- 2005 262 530**
**JP-A- 2006 240 116**
**US-A1- 2002 098 447**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

## BACKGROUND OF THE INVENTION

1. Field of the Invention

The present invention relates to a lithographic printing plate precursor, a method of producing a lithographic printing plate, a printing method, and a method of producing an aluminum support.

2. Description of the Related Art

From the viewpoint that an aluminum support used in a lithographic printing plate improves stain resistance and printing durability in a case where a lithographic printing plate is obtained from the aluminum support, it is known that unevenness is imparted by graining (roughening treatment) a surface of an aluminum plate.
For example, WO2019/087516A discloses "lithographic printing plate precursor including an aluminum support and an image recording layer disposed on the aluminum support, in which the aluminum support includes an aluminum plate and an anodized aluminum film disposed on the aluminum plate, the image recording layer is disposed on the aluminum support on a side of the anodized film, and a density of recesses with a depth of 0.70 μm or greater from a center line, which is obtained by measuring a surface of the aluminum support on a side of the image recording layer in an area of 400 μm × 400 μm using a non-contact three-dimensional roughness meter, is 3,000 pc/mm$^2$ or greater.

## SUMMARY OF THE INVENTION

In a case where printing is performed using a lithographic printing plate obtained by using a lithographic printing plate precursor, a treatment of carrying out cleaning with a cleaner may be performed to remove stains during the printing. It is required that the printing durability is not degraded even after such a treatment with a cleaner is performed. The performance described above is also referred to as oil-based cleaner printing durability.
As a result of examination on the lithographic printing plate precursor described in WO2019/087516A, the present inventors clarified that degradation of the oil-based cleaner printing durability is a problem.
EP 1 577 115 discloses a support for a lithographic printing plate which, when measured over a 400 μm x 400 μm surface region thereon using a three-dimensional non-contact roughness tester, has at most 5.0 convex portions of a height from centerline of at least 0.70 μm and an equivalent circle diameter of at least 20 μm, and has at least 800 concave portions of a depth from centerline of at least 0.50 μm and an equivalent circle diameter of at least 2.0 μm.
An object of the present invention is to provide a lithographic printing plate precursor from which a lithographic printing plate with excellent oil-based cleaner printing durability is obtained.
Further, an object of the present invention is to provide a method of producing a lithographic printing plate, a printing method, and a method of producing an aluminum support.
The present inventors found that the above-described problems can be solved by employing the following configurations.
The invention is as defined in the appended claim set.
According to the present invention, it is possible to provide a lithographic printing plate precursor from which a lithographic printing plate with excellent oil-based cleaner printing durability is obtained.
Further, according to the present invention, it is possible to provide a method of producing a lithographic printing plate, a printing method, and a method of producing an aluminum support.

## BRIEF DESCRIPTION OF THE DRAWINGS

Fig. 1 is a schematic cross-sectional view illustrating an embodiment of a lithographic printing plate precursor of the present invention.
Fig. 2 is a schematic cross-sectional view illustrating an embodiment of an aluminum support.
Fig. 3 is a graph showing an example of an alternating waveform current waveform diagram used for an electrochemical roughening treatment according to a method of producing an aluminum support.
Fig. 4 is a side view illustrating an example of a radial type cell in the electrochemical roughening treatment carried out using an alternating current according to the method of producing an aluminum support.
Fig. 5 is a schematic cross-sectional view illustrating another embodiment of an aluminum support.
Fig. 6 is a schematic view illustrating an anodization treatment device used for an anodization treatment in preparation

of the aluminum support.

## DESCRIPTION OF THE PREFERRED EMBODIMENTS

Hereinafter, the present invention will be described in detail.

The description of constituent elements below is made based on representative embodiments of the present invention in some cases, but the present invention is not limited to such embodiments.

In addition, in the present specification, a numerical range shown using "to" indicates a range including numerical values described before and after "to" as a lower limit and an upper limit.

Further, in the present specification, in a case where substitution or unsubstitution is not noted in regard to the notation of a group in a compound represented by a formula and the group may further have a substituent, the group includes not only an unsubstituted group but also a group having a substituent unless otherwise specified. For example, in a formula, the description of "R represents an alkyl group, an aryl group, or a heterocyclic group" means that "R represents an unsubstituted alkyl group, a substituted alkyl group, an unsubstituted aryl group, a substituted aryl group, an unsubstituted heterocyclic group, or a substituted heterocyclic group".

A lithographic printing plate precursor according to a first embodiment of the present invention is a lithographic printing plate precursor including an aluminum support, and an image recording layer disposed on the aluminum support, in which the aluminum support includes an aluminum plate and an anodized aluminum film disposed on the aluminum plate, the image recording layer is disposed on the aluminum support on a side of the anodized film, and the density of recesses with a depth of 0.40 μm or greater from an average level, which is obtained by measuring a surface of the aluminum support on a side of the image recording layer in an area of 400 μm × 400 μm using a non-contact three-dimensional roughness meter, is 4,000 pc/mm$^2$ or greater.

A lithographic printing plate precursor according to a second embodiment, not in accordance with the present invention, is a lithographic printing plate precursor including an aluminum support, and an image recording layer disposed on the aluminum support, in which the aluminum support includes an aluminum plate and an anodized aluminum film disposed on the aluminum plate, the image recording layer is disposed on the aluminum support on a side of the anodized film, and the area ratio of projections with a height of 0.80 μm or greater from an average level, which is obtained by measuring a surface of the aluminum support on a side of the image recording layer in an area of 400 μm × 400 μm using a non-contact three-dimensional roughness meter, is 20% or less.

The first embodiment and the second embodiment are different from each other in terms that the density of recesses at a predetermined depth is specified in the first embodiment and the area ratio of the projections at a predetermined height is specified in the second embodiment.

Hereinafter, first, the density of recesses at a predetermined depth of the first embodiment and the area ratio of projections at a predetermined height of the second embodiment, which are the features of the embodiments, will be described.

[Density of recesses]

In the lithographic printing plate precursor according to the first embodiment of the present invention, the density of recesses with a depth of 0.40 μm or greater from an average level (hereinafter, also referred to as "first specific recesses"), which is obtained by measuring the surface of the aluminum support on the side of the image recording layer in an area of 400 μm × 400 μm using a non-contact three-dimensional roughness meter, is 8,000 pc/mm$^2$ or greater.

From the viewpoint that the oil-based cleaner printing durability is more excellent (hereinafter, simply referred to as "from the viewpoint that the effects of the present invention are more excellent"), the density of the first specific recesses is 8,000 pc/mm$^2$ or greater. The upper limit of the density of the first specific recesses is not particularly limited, but is preferably 20,000 pc/mm$^2$ or less and more preferably 16,000 pc/mm$^2$ or less.

In the present invention, the density of the first specific recesses denotes a value measured as follows.

First, the surface of the aluminum support on the side of the image recording layer in an area of 400 μm × 400 μm is scanned with a resolution of 0.01 μm in a non-contact manner using a non-contact three-dimensional roughness meter (VertScan, manufactured by Ryoka Systems Inc.), and three-dimensional data is acquired. Further, the device contents and measurement conditions of the VertScan are as follows.

(1) Device contents

CCD camera: Sony HR-57
Objective lens: ×10
Lens barrel: ×1

Wavelength filter: 530 white

(2) Conditions for measurement

Measurement mode: wave
Visual field range: 400 μm × 400 μm
Scan range: start + 6 μm, stop -10 μm

Next, the obtained three-dimensional data is image-analyzed using software (SX Viewer, manufactured by Ryoka Systems Inc.), and "complete interpolation", "surface correction polynomial", "secondary", and "particle analysis" are sequentially selected, and the number of recesses with a depth 0.40 μm or greater from the average level to be obtained is acquired. Further, the average level denotes the surface positioned with a height obtained by averaging the height values of all pieces of measurement data related to the surface of the aluminum support on the side of the image recording layer in a measurement region (400 μm × 400 μm).

The density of the first specific recesses is obtained by measuring five sites for each sample, calculating the number of predetermined recesses at each site, acquiring the average value thereof, and converting the acquired average value into the number of recesses per unit area ($\mu m^2$).

[Area ratio of projections]

In the lithographic printing plate precursor according to the second embodiment, not in accordance with the present invention, the area ratio of projections with a height of 0.80 μm or greater from an average level (hereinafter, also referred to as "specific projections"), which is obtained by measuring the surface of the aluminum support on the side of the image recording layer in an area of 400 μm × 400 μm using a non-contact three-dimensional roughness meter, is 20% or less.

From the viewpoint that the effects of the present invention are more excellent, the area ratio of the specific projections is preferably 13% or less, more preferably 10% or less, still more preferably 8% or less, particularly preferably 7% or less, more particularly preferably less than 3%, and most preferably 2% or less. The lower limit of the area ratio of the specific projections is not particularly limited, but is preferably 0% or greater and more preferably 0.2% or greater.

In the present invention, the area ratio of the specific projections denotes a value measured as follows.

First, the surface of the aluminum support on the side of the image recording layer in an area of 400 μm × 400 μm is scanned with a resolution of 0.01 μm in a non-contact manner using a non-contact three-dimensional roughness meter (VertScan, manufactured by Ryoka Systems Inc.), and three-dimensional data is acquired. Further, the device contents and measurement conditions of the VertScan are as follows.

(1) Device contents

CCD camera: Sony HR-57
Objective lens: ×10
Lens barrel: ×1
Wavelength filter: 530 white

(2) Conditions for measurement

Measurement mode: wave
Visual field range: 400 μm × 400 μm
Scan range: start + 6 μm, stop -10 μm

Next, the obtained three-dimensional data is image-analyzed using software (SX Viewer, manufactured by Ryoka Systems Inc.), projections with a depth of 0.80 μm or greater from the average level to be obtained are extracted, and the area ratio of projections in an area of 400 μm × 400 μm is acquired.

The area ratio of the specific projections is obtained by measuring five sites for each sample, calculating the area

ratio of predetermined projections at each site, and acquiring the average value thereof.

Further, in the lithographic printing plate precursor according to the first embodiment of the present invention, the area ratio of the specific projection is not particularly limited, but is preferably 20% or less from the viewpoint that the effects of the present invention are more excellent. That is, in the lithographic printing plate precursor according to the first embodiment of the present invention, the density of the first specific recesses may be 4,000 pc/mm$^2$ or greater and the area ratio of the specific projections may be 20% or less, which are obtained by measuring the surface of the aluminum support on the side of the image recording layer in an area of 400 $\mu$m $\times$ 400 $\mu$m using a non-contact three-dimensional roughness meter.

From the viewpoint that the effects of the present invention are more excellent, the area ratio of the specific projections in the lithographic printing plate precursor according to the first embodiment of the present invention is preferably 13% or less, more preferably 10% or less, still more preferably 8% or less, and particularly preferably 7% or less. The lower limit of the area ratio of the specific projections is not particularly limited, but is preferably 0% or greater and more preferably 0.3% or greater.

Further, in the lithographic printing plate precursor according to the second embodiment, not in accordance with the present invention, the density of the first specific recesses is not particularly limited, but is preferably 4,000 pc/mm$^2$ or greater from the viewpoint that the effects of the present invention are more excellent. That is, in the lithographic printing plate precursor according to the embodiment of the present invention, the area ratio of the specific projections is 20% or less, the density of the first specific recesses may be 4,000 pc/mm$^2$ or greater.

From the viewpoint that the effects of the present invention are more excellent, the density of the first specific recesses in the lithographic printing plate precursor according to the second embodiment not in accordance with the present invention, is preferably 6,000 pc/mm$^2$ or greater and more preferably 8,000 pc/mm$^2$ or greater. The upper limit of the density of the first specific recesses is not particularly limited, but is preferably 20,000 pc/mm$^2$ or less and more preferably 16,000 pc/mm$^2$ or less.

Hereinafter, the configuration of the lithographic printing plate precursor according to the embodiment of the present invention will be described in more detail, and the configuration described below is a configuration related to both the first embodiment and the second embodiment described above unless otherwise specified.

[Density of recesses]

In the lithographic printing plate precursor (the first embodiment and the second embodiment) of the present invention, the density of recesses with a depth of 0.20 $\mu$m or greater from an average level (hereinafter, also simply referred to as "second specific recesses"), which is obtained by measuring the surface of the aluminum support on the side of the image recording layer in an area of 400 $\mu$m $\times$ 400 $\mu$m using a non-contact three-dimensional roughness meter, is not particularly limited, but is 3,000 pc/mm$^2$ or greater in many cases, and from the viewpoint that the effects of the present invention are more excellent, the density thereof is preferably 6,000 pc/mm$^2$ or greater and more preferably 8,000 pc/mm$^2$ or greater. The upper limit of the density of the second specific recesses is not particularly limited, but is preferably 20,000 pc/mm$^2$ or less and more preferably 16,000 pieces/mm$^2$ or less.

In a method of measuring the second specific recesses, first, measurement is performed under the same conditions using the same non-contact three-dimensional roughness meter (VertScan, manufactured by Ryoka Systems Inc.) as in the measurement of the density of the first specific recesses described above, the obtained three-dimensional data is image-analyzed using software (SX Viewer, manufactured by Ryoka Systems Inc.), and the number of recesses with a depth of 0.20 $\mu$m or greater from the average level to be obtained.

The density of the second specific recesses is obtained by measuring five sites for each sample, calculating the number of predetermined recesses at each site, acquiring the average value thereof, and converting the acquired average value into the number of recesses per unit area ($\mu m^2$).

[Surface area ratio $\Delta$S]

In the lithographic printing plate precursor (the first embodiment and the second embodiment) of the present invention, a surface area ratio $\Delta$S calculated according to Equation (1), from a geometrically measured area S0 and an actual area Sx acquired by an approximate three-point method from three-dimensional data obtained by measuring 512 $\times$ 512 points with an area of 25 $\mu$m $\times$ 25 $\mu$m on the surface of the aluminum support on the side of the image recording layer using an atomic force microscope, is preferably 20% or greater, more preferably 25% or greater, still more preferably 35% or greater, and particularly preferably 45% or greater from the viewpoint that the effects of the present invention are more excellent. The upper limit of the surface area ratio $\Delta$S is not particularly limited, but is preferably 70% or less and more preferably 60% or less.

$$\Delta S = (Sx - S0)/S0 \times 100\ (\%) \cdots (1)$$

In the present invention, the surface area ratio ΔS denotes a value measured as follows.

Specifically, the aluminum support is cut into a size of 1 $cm^2$ and set on a horizontal sample stand that is provided on a piezo scanner, a cantilever is allowed to approach the surface of the sample, the surface is scanned in an XY direction in a case where the cantilever reaches a region where an atomic force works, and the unevenness of the sample is captured by the displacement of the piezo in a Z direction. A piezo scanner capable of performing scanning a distance of 150 μm in the XY direction and a distance of 10 μm in the Z direction is used as the piezo scanner. The measurement is performed using a cantilever having a resonance frequency of 130 kHz to 200 kHz and a spring constant of 7 to 20 N/m (OMCL-AC200-TS, manufactured by Olympus Corporation) in a dynamic force mode (DFM). Further, by carrying out the least squares approximation of the acquired three-dimensional data, the slight inclination of the sample is corrected to acquire a reference surface.

During the measurement, 512 × 512 points in an area of 25 × 25 μm on the surface are measured. The surface area ratio is acquired by setting the resolution in the X direction to 0.05 μm, the resolution in the Y direction to 1.9 μm, the resolution in the Z direction to 1 nm, and the scan speed to 18 μm/sec.

[Surface Roughness Ra]

In the lithographic printing plate precursor (the first embodiment and the second embodiment) of the present invention, the surface roughness Ra obtained by measuring the surface of the aluminum support on the side of the image recording layer using a contact type surface roughness meter is not particularly limited, but is 0.50 μm or less in many cases, and from the viewpoint that the effects of the present invention are more excellent, the surface roughness Ra thereof is preferably 0.45 μm or less, more preferably 0.40 μm or less, and still more preferably 0.35 μm or less. The lower limit of the surface roughness Ra is not particularly limited, but is preferably 0.1 μm or greater and more preferably 0.12 μm or greater.

In the present invention, the surface roughness Ra (arithmetic average roughness Ra) is obtained by extracting a portion having a measurement length L from a roughness curve measured by a stylus type roughness meter in a direction of the center line thereof, and in a case where the center line of the extracted portion is defined as an X-axis, the axis orthogonal to the X-axis is defined as a Y-axis, and the roughness curve is defined as Y = f(X), the value acquired by the following equation is in units of μm (the determination of L and the measurement of the average roughness are made in conformity with JIS B 0601).

$$Ra = \frac{1}{L}\int_0^L \left| f(X) \right| dX$$

Examples of a suitable aspect of the lithographic printing plate precursor (the first embodiment and the second embodiment) of the present invention include a lithographic printing plate precursor in which the area ratio of the specific projections is 10% or less, the density of the second specific recesses is 6,000 pc/$mm^2$ or greater, and the surface area ratio ΔS is 45% or greater from the viewpoint that the effects of the present invention are more excellent.

Other examples of a suitable aspect of the lithographic printing plate precursor (the first embodiment and the second embodiment) of the present invention include a lithographic printing plate precursor in which the area ratio of the specific projections is 10% or less and the surface area ratio ΔS is 20% or greater from the viewpoint that the effects of the present invention are more excellent.

Other examples of a suitable aspect of the lithographic printing plate precursor (the first embodiment and the second embodiment) of the present invention include a lithographic printing plate precursor in which the area ratio of the specific projections is 10% or less and the surface area ratio ΔS is 45% or greater from the viewpoint that the effects of the present invention are more excellent.

Other examples of a suitable aspect of the lithographic printing plate precursor (the first embodiment and the second embodiment) of the present invention include a lithographic printing plate precursor in which the area ratio of the specific projections is 7% or less and the surface area ratio ΔS is 20% or greater from the viewpoint that the effects of the present invention are more excellent.

Other examples of a suitable aspect of the lithographic printing plate precursor (the first embodiment and the second embodiment) of the present invention include a lithographic printing plate precursor in which the area ratio of the specific projections is 7% or less and the surface area ratio ΔS is 45% or greater from the viewpoint that the effects of the present invention are more excellent.

Further, in the present invention, from the viewpoint of improving visibility, the value of a lightness L* in the L*a*b* color system of the surface of the aluminum support on the side of the image recording layer, that is, the surface of the anodized film is preferably in a range of 68 to 90 and more preferably in a range of 75 to 90.

Further, the value of a* in the L*a*b* color system is preferably in a range of -4 to 4, and the value of b* is preferably in a range of -4 to 4.

Here, as L*, a*, and b* in the L*a*b* color system, an average value obtained by performing measurement five times using a color difference meter (for example, CR-221, manufactured by Konica Minolta, Inc.) is employed.

Fig. 1 is a schematic cross-sectional view illustrating an embodiment of the lithographic printing plate precursor of the present invention.

A lithographic printing plate precursor 10 illustrated in Fig. 1 includes an aluminum support 12a, and an image recording layer 16 disposed on the aluminum support 12a, and as illustrated in Fig. 1, it is preferable that the lithographic printing plate precursor 10 further includes an undercoat layer 14 between the aluminum support 12a and the image recording layer 16.

Fig. 2 is a schematic cross-sectional view illustrating an embodiment of the aluminum support 12a. The aluminum support 12a has a laminated structure in which an aluminum plate 18 and an anodized aluminum film 20a (hereinafter, also simply referred to as "anodized film 20a") are laminated in this order. Further, the anodized film 20a in the aluminum support 12a is positioned on the side of the image recording layer 16. That is, the lithographic printing plate precursor 10 includes the aluminum plate 18, the anodized film 20a, an undercoat layer 14, and the image recording layer 16 in this order.

Further, it is preferable that the anodized film 20a has micropores 22a extending from the surface thereof toward the side of the aluminum plate 18 as illustrated in Fig. 2. Further, the term "micropores" here is a general term used to indicate pores in the anodized film and does not specify the size of the pore.

As described in detail below, the undercoat layer 14 is not an indispensable component and is a layer to be disposed as necessary.

Hereinafter, each configuration of the lithographic printing plate 10 will be described in detail.

[Aluminum plate]

The aluminum plate 18 (aluminum support) is a metal, which is dimensionally stable and contains aluminum as a main component, and is formed of aluminum or an aluminum alloy. Examples of the aluminum plate 18 include a pure aluminum plate, an alloy plate containing aluminum as a main component and a trace amount of foreign elements, and a plastic film or paper formed by laminating or depositing aluminum (alloy).

Examples of the foreign elements contained in the aluminum alloy include a silicon element, an iron element, a manganese element, a copper element, a magnesium element, a chromium element, a zinc element, a bismuth element, a nickel element, and a titanium element, and the content of the foreign elements in the alloy is 10% by mass or less. As the aluminum plate 18, a pure aluminum plate is suitable, but completely pure aluminum is difficult to produce in terms of smelting technology, and thus the aluminum plate may contain a trace amount of foreign elements.

The composition of the aluminum plate 18 is not particularly limited, and publicly known materials can be appropriately used (for example, **JIS** A 1050, **JIS** A 1100, **JIS** A 3103, and **JIS** A 3005).

Further, the width of the aluminum plate 18 is preferably approximately 400 to 2,000 mm, and the thickness thereof is preferably approximately 0.1 to 0.6 mm. The width and the thickness thereof can be appropriately changed depending on the size of the printing press, the size of the printing plate, and the user's desire.

[Anodized film]

The anodized film 20a is a film to be prepared typically on a surface of the aluminum plate 18 by performing an anodization treatment, and this film is substantially perpendicular to the film surface and has extremely fine micropores 22a uniformly distributed. The micropores 22a extend along the thickness direction (the aluminum plate 18 side) from the surface of the anodized film 20a on the side of the image recording layer 16 (the surface of the anodized film 20a on a side opposite to a side where the aluminum plate 18 is provided).

The average diameter (average opening diameter) of the micropores 22a in the surface of the anodized film 20a is preferably in a range of 10 to 150 nm and more preferably in a range of 10 to 100 nm. Among these, from the viewpoint of the balance between stain resistance and image visibility, the average diameter thereof is still more preferably in a range of 15 to 100 nm, particularly preferably in a range of 15 to 60 nm, more particularly preferably in a range of 20 to 50 nm, and most preferably in a range of 25 to 40 nm. The same effects can be obtained regardless of whether the inner diameter of the pores is greater or less than that of the surface layer.

The average diameter of micropores 22a is obtained by observing 4 sheets (N = 4) of the surfaces of the anodized film 20a using a field emission scanning electron microscope (FE-SEM) at a magnification of 150,000, measuring the

diameters of micropores present in an area of 400 × 600 $nm^2$ in the obtained four sheets of images, and averaging the values.

Further, in a case where the shape of the micropores 22a is not circular, an equivalent circle diameter is used. The "equivalent circle diameter" is a diameter of a circle obtained by assuming the shape of an opening portion of a micropore as a circle having the same projected area as the projected area of the opening portion.

The depth of the micropores 22a is not particularly limited, but is preferably in a range of 10 nm to 3,000 nm, more preferably in a range of 50 nm to 2,000 nm, and still more preferably 300 nm to 1,600 nm.

Further, the depth thereof is a value obtained by capturing (150,000 times) an image of a cross section of the anodized film 20a, measuring the depth of 25 or more micropores 22a, and averaging the obtained values.

The shape of the micropores 22a is not particularly limited, and the shape thereof in Fig. 2 may be a substantially straight tubular shape (substantially columnar shape), but may be a conical shape whose diameter decreases toward the depth direction (thickness direction). Further, the shape of the bottom portion of the micropores 22a is not particularly limited, but may be a curved shape (projection shape) or a planar shape.

[Undercoat layer]

The undercoat layer 14 is a layer disposed between the aluminum support 12a and the image recording layer 16 and improves the adhesiveness between the aluminum support and the image recording layer. As described above, the undercoat layer 14 is a layer provided as necessary and may not be provided in the lithographic printing plate precursor.

The configuration of the undercoat layer is not particularly limited, but it is preferable that the undercoat layer contains polyvinylphosphonic acid from the viewpoint of suppressing ink adhesiveness in a non-image area while maintaining printing durability.

Here, as the polyvinylphosphonic acid, those disclosed in US3276868A, US4153461A, and US4689272A can be used.

The configuration of the undercoat layer is not particularly limited, but it is preferable that the undercoat layer contains a compound having a betaine structure from the viewpoint that the stain resistance and deinking capability after being left to stand are more excellent.

Here, the betaine structure denotes a structure having at least one cation and at least one anion. Further, the number of cations is typically the same as the number of anions so as to be neutral as a whole. However, according to the present invention, in a case where the number of cations is not the same as the number of anions, the charge is cancelled by having a required amount of counter ions so that the betaine structure is obtained.

It is preferable that the betaine structure is any of the structures represented by Formulae (1), (2), and (3).

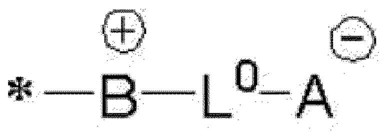

Formula (1)

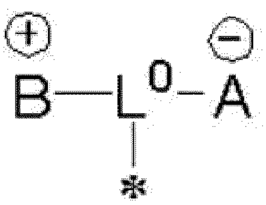

Formula (2)

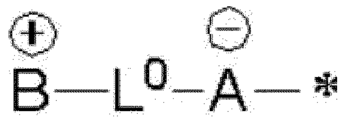

Formula (3)

In the formulae, $A^-$ represents a structure having an anion, $B^+$ represents a structure having a cation, and $L^0$ represents a linking group. The symbol "*" represents a linking site (linking position).

It is preferable that $A^-$ represents a structure having an anion such as a carboxylate, a sulfonate, a phosphonate, or a phosphinate and $B^+$ represents a structure having a cation such as ammonium, phosphonium, iodonium, or sulfonium.

$L^0$ represents a linking group. In Formulae (1) and (3), examples of $L^0$ include divalent linking groups. Among these, -CO-, -O-, -NH-, a divalent aliphatic group, a divalent aromatic group, or a combination thereof is preferable. In Formula (2), examples of $L^0$ include trivalent linking groups.

A linking group having 30 or less carbon atoms including the number of carbon atoms of the following substituent which may be included is preferable as the linking group.

Specific examples of the linking group include an alkylene group (having preferably 1 to 20 carbon atoms and more preferably 1 to 10 carbon atoms) and an arylene group (having preferably 5 to 15 carbon atoms and more preferably 6 to 10 carbon atoms) such as a phenylene group or a xylylene group.

Further, these linking groups may further have substituents.

Examples of the substituent include a halogen atom, a hydroxyl group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group, and a diarylamino group.

From the viewpoint that at least one of the printing durability, the stain resistance, the deinking capability after

being left to stand, or the image visibility is more excellent, a structure represented by Formula (i), (ii), or (iii) is preferable, and a structure represented by Formula (i) is more preferable as the betaine structure. The symbol "*" represents a linking site.

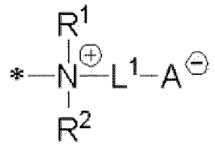
(i)

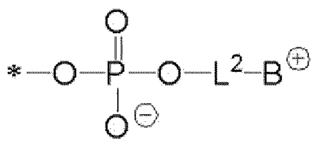
(ii)

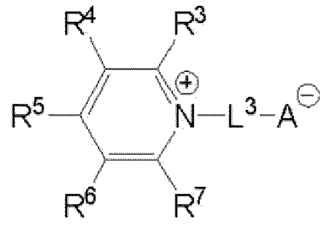
(iii)

In Formula (i), $R^1$ and $R^2$ each independently represent a hydrogen atom, an alkyl group, an alkenyl group, an alkynyl group, an aryl group, or a heterocyclic group, and $R^1$ and $R^2$ may be linked to each other to form a ring structure.
The ring structure may have heteroatoms such as an oxygen atom. As the ring structure, a 5- to 10-membered ring is preferable and a 5- or 6-membered ring is more preferable.
The number of carbon atoms in $R^1$ and $R^2$ is preferably in a range of 1 to 30 and more preferably in a range of 1 to 20.
From the viewpoint of further improving the effects of the present invention, it is preferable that $R^1$ and $R^2$ represent a hydrogen atom, a methyl group, or an ethyl group.
$L^1$ represents a divalent linking group and preferably -CO-, -O-, -NH-, a divalent aliphatic group (such as an alkylene group), a divalent aromatic group (such as a phenylene group), or a combination thereof.
It is preferable that $L^1$ represents a linear alkylene group having 3 to 5 carbon atoms.
In Formula (i), $A^-$ represents a structure having an anion and preferably a carboxylate, a sulfonate, a phosphonate, or a phosphinate.
Specific examples thereof include the following structures.

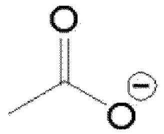 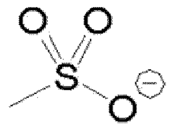 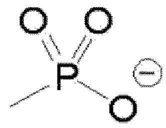 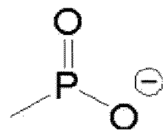

In Formula (i), a combination in which $L^1$ represents a linear alkylene group having 4 or 5 carbon atoms and $A^-$ represents a sulfonate is preferable, and a combination in which $L^1$ represents a linear alkylene group having 4 carbon atoms and $A^-$ represents a sulfonate is more preferable.
In Formula (ii), $L^2$ represents a divalent linking group and preferably -CO-, -O-, -NH-, a divalent aliphatic group (such as an alkylene group), a divalent aromatic group (such as a phenylene group), or a combination thereof.
$B^+$ represents a structure having a cation and preferably a structure having ammonium, phosphonium, iodonium, or sulfonium. Among these, a structure having ammonium or phosphonium is preferable, and a structure having ammonium is more preferable.
Examples of the structure having a cation include a trimethylammonio group, a triethylammonio group, a tributylammonio group, a benzyldimethylammonio group, a diethylhexylammonio group, a (2-hydroxyethyl)dimethylammonio group, a pyridinio group, a N-methylimidazolio group, a N-acridinio group, a trimethylphosphonio group, a triethylphosphonio group, and a triphenylphosphonio group.
In Formula (iii), $L^3$ represents a divalent linking group and preferably -CO-, -O-, -NH-, a divalent aliphatic group (such as an alkylene group), a divalent aromatic group (such as a phenylene group), or a combination thereof.
$A^-$ represents a structure having an anion and preferably a carboxylate, a sulfonate, a phosphonate, or a phosphinate. Further, the details and preferred examples thereof are the same as those for A- in Formula (i).
$R^3$ to $R^7$ each independently represent a hydrogen atom or a substituent (having preferably 1 to 30 carbon atoms), and at least one of $R^3$ to $R^7$ represents a linking site.
At least one of $R^3$ to $R^7$ as a linking site may be linked to another site in the compound through a substituent as at least one of $R^3$ to $R^7$ or may be directly linked to another site in the compound through a single bond.
Examples of the substituents represented by $R^3$ to $R^7$ include a halogen atom, an alkyl group, (such as a cycloalkyl group or a bicycloalkyl group), an alkenyl group (such as a cycloalkenyl group or a bicycloalkenyl group), an alkynyl group, an aryl group, a heterocyclic group, a cyano group, a hydroxyl group, a nitro group, a carboxyl group, an

alkoxy group, an aryloxy group, a silyloxy group, a heterocyclic oxy group, an acyloxy group, a carbamoyloxy group, an alkoxycarbonyloxy group, an aryloxycarbonyloxy group, an amino group (such as an anilino group), an acylamino group, an aminocarbonylamino group, an alkoxycarbonylamino group, an aryloxycarbonylamino group, a sulfamoylamino group, an alkyl and arylsulfonylamino group, a mercapto group, an alkylthio group, an arylthio group, a heterocyclic thio group, a sulfamoyl group, a sulfo group, an alkyl and arylsulfinyl group, an alkyl and arylsulfonyl group, an acyl group, an aryloxycarbonyl group, an alkoxycarbonyl group, a carbamoyl group, an aryl and heterocyclic azo group, an imide group, a phosphino group, a phosphinyl group, a phosphinyloxy group, a phosphinylamino group, and a silyl group.

From the viewpoint that the effects of the present invention are more excellent, it is preferable that the compound is a polymer having a repeating unit with a betaine structure (hereinafter, also simply referred to as "specific polymer"). As the repeating unit with a betaine structure, a repeating unit represented by Formula (A1) is preferable.

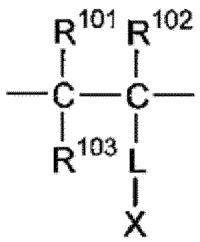

(A1)

In the formula, $R^{101}$ to $R^{103}$ each independently represent a hydrogen atom, an alkyl group, or a halogen atom. L represents a single bond or a divalent linking group.

Examples of the divalent linking group include -CO-, -O-, -NH-, a divalent aliphatic group, a divalent aromatic group, and a combination thereof.

Specific examples of L formed of the above-described combination are listed below. In each of the following examples, the left side is bonded to the main chain and the right side is bonded to X.

L1: -CO-O-divalent aliphatic group-
L2: -CO-O-divalent aromatic group-
L3: -CO-NH-divalent aliphatic group-
L4: -CO-NH-divalent aromatic group-
L5: -CO-divalent aliphatic group-
L6: -CO-divalent aromatic group-
L7: -CO-divalent aliphatic group-CO-O-divalent aliphatic group-
L8: -CO-divalent aliphatic group-O-CO-divalent aliphatic group-
L9: -CO-divalent aromatic group-CO-O-divalent aliphatic group-
L10: -CO-divalent aromatic group-O-CO-divalent aliphatic group-
L11: -CO-divalent aliphatic group-CO-O-divalent aromatic group-
L12: -CO-divalent aliphatic group-O-CO-divalent aromatic group-
L13: -CO-divalent aromatic group-CO-O-divalent aromatic group-
L14: -CO-divalent aromatic group-O-CO-divalent aromatic group-
L15: -CO-O-divalent aromatic group-O-CO-NH-divalent aliphatic group-
L16: -CO-O-divalent aliphatic group-O-CO-NH-divalent aliphatic group-

Examples of the divalent aliphatic group include an alkylene group, an alkenylene group, and an alkynylene group.

Examples of the divalent aromatic group include an aryl group. Further, a phenylene group or a naphthylene group is preferable.

X represents a betaine structure. It is preferable that X represents a structure represented by Formula (i), Formula (ii), or Formula (iii).

Particularly, in Formula (A1), a combination in which L represents L1 or L3, X represents a structure represented by Formula (i), and $A^-$ in Formula (i) represents a sulfonate group is preferable.

The content of the repeating unit having a betaine structure in the specific polymer is not particularly limited, but is in a range of 20% to 95% by mass in many cases, and from the viewpoint of further improving the effects of the present invention, preferably in a range of 50% to 95% by mass and more preferably in a range of 60% to 90% by mass with respect to the total amount of all repeating units constituting the specific polymer.

The specific polymer may have repeating units other than the repeating unit having a betaine structure.

The specific polymer may have a repeating unit having a structure (hereinafter, also simply referred to as

"interaction structure") that interacts with the surface of the aluminum support 12a.

Examples of the interaction structure include a carboxylic acid structure, a carboxylate structure, a sulfonic acid structure, a sulfonate structure, a phosphonic acid structure, a phosphonate structure, a phosphoric acid ester structure, a phosphoric acid ester salt structure, a β-diketone structure, and a phenolic hydroxyl group. Among these, a carboxylic acid structure, a carboxylate structure, a sulfonic acid structure, a sulfonate structure, a phosphonic acid structure, a phosphonate structure, a phosphoric acid ester structure, or a phosphoric acid ester salt structure is preferable.

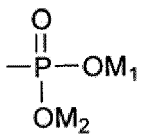 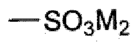 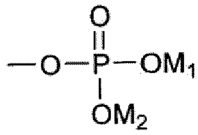 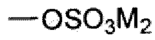

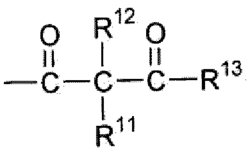 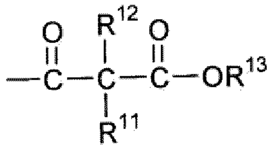 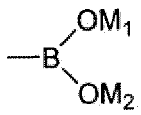 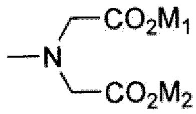

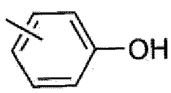 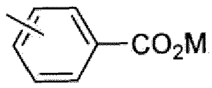 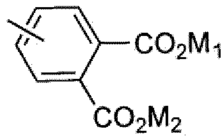

In the formulae, $R^{11}$ to $R^{13}$ each independently represent a hydrogen atom, an alkyl group, an aryl group, an alkynyl group, or an alkenyl group, and M, $M_1$, and $M_2$ each independently represent a hydrogen atom, a metal atom (such as an alkali metal atom such as Na or Li), or an ammonium group. B represents a boron atom.

As the repeating unit having an interaction structure, a repeating unit represented by Formula (A2) is preferable.

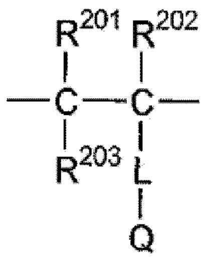 (A2)

In the formula, $R^{201}$ to $R^{203}$ each independently represent a hydrogen atom, an alkyl group (having preferably 1 to 6 carbon atoms), or a halogen atom.

L represents a single bond or a divalent linking group. Examples of the divalent linking group include -CO-, -O-, -NH-, a divalent aliphatic group, a divalent aromatic group, and a combination thereof.

Specific examples of L formed of the above-described combination include the same structures for Formula (A1), and L17 and L18.

L17: -CO-NH-

L18: -CO-O-

Among L1 to L18, L1 to L4, L17, or L18 is preferable.

Q represents an interaction structure, and the preferable aspect thereof is the same as described above.

The content of the repeating unit having an interaction structure in the specific polymer is not particularly limited, but is preferably in a range of 1% to 40% by mass and more preferably in a range of 3% to 30% by mass with respect to the total amount of all repeating units constituting the specific polymer from the viewpoint of further improving the effects of the present invention.

The specific polymer may have a repeating unit that contains a radically polymerizable reactive group.

Examples of the radically polymerizable reactive group include an addition-polymerizable unsaturated bonding

group (such as a (meth)acryloyl group, a (meth)acrylamide group, a (meth)acrylonitrile group, an allyl group, a vinyl group, a vinyloxy group, or an alkynyl group) and a functional group capable of chain transfer (such as a mercapto group).

The specific polymer having a repeating unit that contains a radically polymerizable group can be obtained by introducing a radically polymerizable reactive group using the method described in JP2001-312068A. Excellent developability is exhibited in an unexposed portion, the permeability of the developer is suppressed by the polymerization in an exposed portion, and the adhesion property and the adhesiveness between the aluminum support 12a and the image recording layer 16 are further improved, by using the specific polymer having a repeating unit that contains a radically polymerizable reactive group.

The content of the repeating unit that contains a radically polymerizable reactive group in the specific polymer is not particularly limited, but is preferably in a range of 1% to 30% by mass and more preferably in a range of 3% to 20% by mass with respect to the total amount of all repeating units constituting the specific polymer from the viewpoint that the effects of the present invention are more excellent.

The content of the compound having a betaine structure in the undercoat layer 14 is not particularly limited, but is preferably 80% by mass or greater and more preferably 90% by mass or greater with respect to the total mass of the undercoat layer. The upper limit thereof is, for example, 100% by mass.

Hereinbefore, the undercoat layer 14 that contains a compound with a betaine structure has been described, but the undercoat layer may contain another compound.

For example, the undercoat layer may contain a compound that contains a hydrophilic group. Examples of the hydrophilic group include a carboxylic acid group and a sulfonic acid group.

The compound that contains a hydrophilic group may further contain a radically polymerizable group.

[Image recording layer]

As an image recording layer 16, an image recording layer which can be removed by a printing ink and/or dampening water is preferable.

Hereinafter, each constituent component of the image recording layer 16 will be described.

<Infrared absorbing agent>

It is preferable that the image recording layer 16 contains an infrared absorbing agent.

It is preferable that the infrared absorbing agent has a maximum absorption wavelength at a wavelength range of 750 to 1,400 nm. Particularly, since on-press development is carried out by a printing press under white light in an on-press development type lithographic printing plate precursor, a lithographic printing plate precursor with excellent developability can be obtained by using an infrared absorbing agent having a maximum absorption wavelength at a wavelength range of 750 to 1,400 nm, which is not easily affected by the white light.

A dye or a pigment is preferable as the infrared absorbing agent.

As the dye, commercially available dyes and known dyes described in the literatures, for example, "Dye Handbook" (edited by The Society of Synthetic Organic Chemistry, Japan, published in 1970) are exemplified.

Specific examples of the dye include a cyanine coloring agent, a squarylium coloring agent, a pyrylium salt, a nickel thiolate complex, and an indolenine cyanine coloring agent. Among these, a cyanine coloring agent or an indolenine cyanine coloring agent is preferable, a cyanine coloring agent is more preferable, and a cyanine coloring agent represented by Formula (a) is still more preferable.

Formula (a)

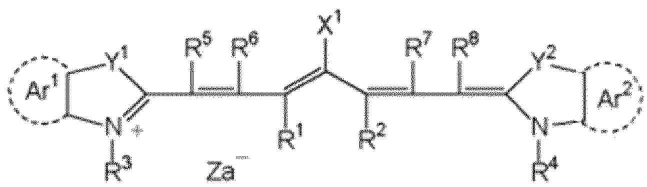

In Formula (a), $X^1$ represents a hydrogen atom, a halogen atom, $-N(R^9)(R^{10})$, $-X^2-L^1$, or a group shown below.

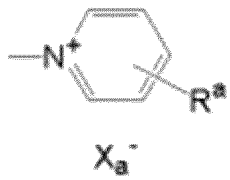

$R^9$ and $R^{10}$ each independently represent an aromatic hydrocarbon group, an alkyl group, or a hydrogen atom, and $R^9$ and $R^{10}$ may be bonded to each other to form a ring. Among these, a phenyl group is preferable.
$X^2$ represents an oxygen atom or a sulfur atom, and $L^1$ represents a hydrocarbon group having 1 to 12 carbon atoms which may have heteroatoms (such as N, S, O, a halogen atom, and Se).
$X_a^-$ has the same definition as that for $Z_a^-$ described below, and $R^a$ represents a hydrogen atom, an alkyl group, an aryl group, an amino group, or a halogen atom.
$R^1$ and $R^2$ each independently represent a hydrocarbon group having 1 to 12 carbon atoms. Further, $R^1$ and $R^2$ may be bonded to each other to form a ring, and it is preferable that a 5- or 6-membered ring is formed during the formation of a ring.
$Ar^1$ and $Ar^2$ each independently represent an aromatic hydrocarbon group which may have a substituent (for example, an alkyl group). As the aromatic hydrocarbon group, a benzene ring group or a naphthalene ring group is preferable.
$Y^1$ and $Y^2$ each independently represent a sulfur atom or a dialkyl methylene group having 12 or less carbon atoms.
$R^3$ and $R^4$ each independently represent a hydrocarbon group having 20 or less carbon atoms which may have a substituent (such as an alkoxy group).
$R^5$, $R^6$, $R^7$, and $R^8$ each independently represent a hydrogen atom or a hydrocarbon group having 12 or less carbon atoms.
Further, $Za^-$ represents a counter anion. Here, $Za^-$ is not necessary in a case where the cyanine coloring agent represented by Formula (a) has an anionic substituent in the structure thereof and neutralization of the charge is not required. Examples of $Za^-$ include a halide ion, a perchlorate ion, a tetrafluoroborate ion, a hexafluorophosphate ion, and a sulfonate ion. Among these, a perchlorate ion, a hexafluorophosphate ion, or an arylsulfonate ion is preferable.
The above-described infrared absorbing dyes may be used alone or in combination of two or more kinds thereof. Further, infrared absorbing agents other than the infrared absorbing dyes such as pigments may be used in combination. As the pigments, the compounds described in paragraphs [0072] to [0076] in JP2008-195018A are preferable.
The content of the infrared absorbing agent is preferably in a range of 0.05% to 30% by mass and more preferably in a range of 0.1% to 20% by mass with respect to the total mass of the image recording layer 16.

<Polymerization initiator>

It is preferable that the image recording layer 16 contains a polymerization initiator.
As the polymerization initiator, a compound (so-called radical polymerization initiator) that generates a radical using light, heat, or the energy of both light and heat and initiates polymerization of a compound containing a polymerizable unsaturated group is preferable. Examples of the polymerization initiator include a photopolymerization initiator and a thermal polymerization initiator.
As the polymerization initiator, specifically, the polymerization initiators described in paragraphs [0115] to [0141] described in JP2009-255434A can be used.
Further, from the viewpoints of the reactivity and the stability, an oxime ester compound or an onium salt such as a diazonium salt, an iodonium salt, or a sulfonium salt is preferable as the polymerization initiator.
The content of the polymerization initiator is preferably in a range of 0.1% to 50% by mass and more preferably in a range of 0.5% to 30% by mass with respect to the total mass of the image recording layer 16.

<Polymerizable compound>

It is preferable that the image recording layer 16 contains a polymerizable compound.
As the polymerizable compound, an addition-polymerizable compound having at least one ethylenically unsaturated bond is preferable. Among the examples, a compound having at least one (preferably two) terminal ethylenically unsaturated bond is more preferable. A so-called radically polymerizable compound is more preferable.
Examples of the polymerizable compound include the polymerizable compounds described in paragraphs [0142] to [0163] of JP2009-255434A.
Further, a urethane-based addition-polymerizable compound produced using the addition reaction between

isocyanate and a hydroxyl group is also suitable. Specific examples thereof include a vinyl urethane compound containing two or more polymerizable vinyl groups in one molecule which is obtained by adding a vinyl monomer that contains a hydroxyl group represented by Formula (A) to a polyisocyanate compound containing two or more isocyanate groups in one molecule described in JP1973-041708B (JP-S48-041708B).

$$CH_2=C(R^4)COOCH_2CH(R^5)OH \qquad (A)$$

(Here, $R^4$ and $R^5$ represent H or $CH_3$.)

The content of the polymerizable compound is preferably in a range of 3% to 80% by mass and more preferably in a range of 10% to 75% by mass with respect to the total mass of the image recording layer 16.

<Binder polymer>

It is preferable that the image recording layer 16 further contains a binder polymer.

Examples of the binder polymer include known binder polymers. Specific examples of the binder polymer include an acrylic resin, a polyvinyl acetal resin, a polyurethane resin, a polyurea resin, a polyimide resin, a polyamide resin, an epoxy resin, a methacrylic resin, a polystyrene-based resin, a novolak type phenol-based resin, a polyester resin, synthetic rubber, and natural rubber.

The binder polymer may have crosslinking properties in order to improve coated-film hardness of an image area. In order to allow the binder polymer to have the crosslinking property, a crosslinkable functional group such as an ethylenically unsaturated bond may be introduced to the main chain or a side chain of the polymer. The crosslinkable functional group may be introduced by copolymerization.

As the binder polymer, for example, the binder polymers disclosed in paragraphs [0165] to [0172] of JP2009-255434A can be used.

The content of the binder polymer is preferably in a range of 5% to 90% by mass and more preferably in a range of 5% to 70% by mass with respect to the total mass of the image recording layer 16.

<Surfactant>

The image recording layer 16 may contain a surfactant in order to promote the on-press developability in a case of start of printing and improve the state of the coated surface.

Examples of the surfactant include a nonionic surfactant, an anionic surfactant, a cationic surfactant, an amphoteric surfactant, and a fluorine-based surfactant.

As the surfactant, the surfactants disclosed in paragraphs [0175] to [0179] of JP2009-255434A can be used.

The content of the surfactant is preferably in a range of 0.001% to 10% by mass and more preferably in a range of 0.01% to 5% by mass with respect to the total mass of the image recording layer 16.

<Color developing agent>

The image recording layer 16 contains preferably a color developing agent and more preferably an acid color developing agent.

The term "color developing agent" used in the present disclosure denotes a compound having a property of changing the color of the image recording layer by developing or decoloring the color thereof using stimulation of light, an acid, or the like and the term "acid color developing agent" denotes a compound having a property of changing the color of the image recording layer by heating the layer in a state of accepting an electron-accepting compound (a proton of an acid or the like) so that the layer is color-developed or decolored. As the acid color developing agent, a colorless compound which has a partial skeleton such as a lactone, a lactam, a sultone, a spiropyran, an ester, or an amide and in which these partial skeletons are rapidly ring-opened or cleaved in a case of being brought into contact with an electron-accepting compound is particularly preferable.

Examples of such an acid color developing agent include phthalides such as 3,3-bis(4-dimethylaminophenyl)-6-dimethylaminophthalide (referred to as "crystal violet lactone"), 3,3-bis(4-dimethylaminophenyl)phthalide, 3-(4-dimethylaminophenyl)-3-(4-diethylamino-2-methylphenyl)-6-dimethylaminophthalide, 3-(4-dimethylaminophenyl)-3-(1,2-dimethylindol-3-yl)phthalide, 3-(4-dimethylaminophenyl)-3-(2-methylindol-3-yl)phthalide, 3,3-bis(1,2-dimethylindol-3-yl)-5-dimethylaminophthalide, 3,3-bis(1,2-dimethylindol-3-yl)-6-dimethylaminophthalide, 3,3-bis(9-ethylcarbazol-3-yl)-6-dimethylaminophthalide, 3,3-bis(2-phenylindol-3-yl)-6-dimethylaminophthalide, and 3-(4-dimethylaminophenyl)-3-(1-methylpyrrol-3-yl)-6-dimethylaminophthalide,

3,3-bis[1,1-bis(4-dimethylaminophenyl)ethylene-2-yl]-4,5,6,7-tetrachlorophthalide, 3,3-bis[1,1-bis(4-pyrrolidinophenyl)ethylene-2-yl]-4,5,6,7-tetrabromophthalide, 3,3-bis[1-(4-dimethylaminophenyl)-1-(4-methoxyphenyl)ethylene-2-yl]-4,5,6,7-tetrachloropht halide, 3,3-bis[1-(4-pyrrolidinophenyl)-1-(4-methoxyphenyl)ethylene-2-yl]4,5,6,7-tetrachlorophthalid e, 3-[1,1-di(1-ethyl-2-methylindol-3-yl)ethylene-2-yl]-3-(4-diethylaminophenyl)phthalide, 3-[1,1-di(1-ethyl-2-methylindol-3-yl)ethylene-2-yl]-3-(4-N-ethyl-N-phenylaminophenyl)phtha lide, 3-(2-ethoxy-4-diethylaminophenyl)-3-(1-n-octyl-2-methylindol-3-yl)-phthalide, 3,3-bis(1-n-octyl-2-methylindol-3-yl)-phthalide, and 3-(2-methyl-4-diethylaminophenyl)-3-(1-n-octyl-2-methylindol-3-yl)-phthalide,

4,4-bis-dimethylaminobenzhydrinbenzylether, N-halophenyl-leucoauramine, N-2,4,5-trichlorophenyl leucoauramine, rhodamine-B-anilinolactam, rhodamine-(4-nitroanilino)lactam, rhodamine-B-(4-chloroanilino)lactam, 3,7-bis(diethylamino)-10-benzoylphenoxazine, benzoyl leucomethylene blue, and 4-nitrobenzoyl methylene blue,

fluorans such as 3,6-dimethoxyfluoran, 3-dimethylamino-7-methoxyfluoran, 3-diethylamino-6-methoxyfluoran, 3-diethylamino-7-methoxyfluoran, 3-diethylamino-7-chlorofluoran, 3-diethylamino-6-methyl-7-chlorofluoran, 3-diethylamino-6,7-dimethylfluoran, 3-N-cyclohexyl-N-n-butylamino-7-methylfluoran, 3-diethylamino-7-dibenzylaminofluoran, 3-diethylamino-7-octylaminofluoran, 3-diethylamino-7-di-n-hexylaminofluoran, 3-diethylamino-7-anilinofluoran, 3-diethylamino-7-(2'-fluorophenylamino)fluoran, 3-diethylamino-7-(2'-chlorophenylamino)fluoran, 3-diethylamino-7-(3'-chlorophenylamino)fluoran, 3-diethylamino-7-(2',3'-dichlorophenylamino)fluoran, 3-diethylamino-7-(3'-trifluoromethylphenylamino)fluoran, 3-di-n-butylamino-7-(2'-fluorophenylamino)fluoran, 3-di-n-butylamino-7-(2'chlorophenylamino)fluoran, 3-N-isopentyl-N-ethylamino-7-(2'-chlorophenylamino)fluoran,

3-N-n-hexyl-N-ethylamino-7-(2'-chlorophenylamino)fluoran, 3-diethylamino-6-chloro-7-anilinofluoran, 3-di-n-butylamino-6-chloro-7-anilinofluoran, 3-diethylamino-6-methoxy-7-anilinofluoran, 3-di-n-butylamino-6-ethoxy-7-anilinofluoran, 3-pyrrolidino-6-methyl-7-anilinofluoran, 3-piperidino-6-methyl-7-anilinofluoran, 3-morpholino-6-methyl-7-anilinofluoran, 3-dimethylamino-6-methyl-7-anilinofluoran, 3-diethylamino-6-methyl-7-anilinofluoran, 3-di-n-butylamino-6-methyl-7-anilinofluoran, 3-di-n-pentylamino-6-methyl-7-anilinofluoran, 3-N-ethyl-N-methylamino-6-methyl-7-anilinofluoran, 3-N-n-propyl-N-methylamino-6-methyl-7-anilinofluoran, 3-N-n-propyl-N-ethylamino-6-methyl-7-anilinofluoran, 3-N-n-butyl-N-methylamino-6-methyl-7-anilinofluoran, 3-N-n-butyl-N-ethylamino-6-methyl-7-anilinofluoran, 3-N-isobutyl-N-methylamino-6-methyl-7-anilinofluoran, 3-N-isobutyl-N-ethylamino-6-methyl-7-anilinofluoran, 3-N-isopentyl-N-ethylamino-6-methyl-7-anilinofluoran, 3-N-n-hexyl-N-methylamino-6-methyl-7-anilinofluoran, 3-N-cyclohexyl-N-ethylamino-6-methyl-7-anilinofluoran, 3-N-cyclohexyl-N-n-propylamino-6-methyl-7-anilinofluoran, 3-N-cyclohexyl-N-n-butylamino-6-methyl-7-anilinofluoran, 3-N-cyclohexyl-N-n-hexylamino-6-methyl-7-anilinofluoran, 3-N-cyclohexyl-N-n-octylamino-6-methyl-7-anilinofluoran,

3-N-(2'-methoxyethyl)-N-methylamino-6-methyl-7-anilinofluoran, 3-N-(2'-methoxyethyl)-N-ethylamino-6-methyl-7-anilinofluoran, 3-N-(2'-methoxyethyl)-N-isobutylamino-6-methyl-7-anilinofluoran, 3-N-(2'-ethoxyethyl)-N-methylamino-6-methyl-7-anilinofluoran, 3-N-(2'-ethoxyethyl)-N-ethylamino-6-methyl-7-anilinofluoran, 3-N-(3'-methoxypropyl)-N-methylamino-6-methyl-7-anilinofluoran, 3-N-(3'methoxypropyl)-N-ethylamino-6-methyl-7-anilinofluoran, 3-N-(3'-ethoxypropyl)-N-methylamino-6-methyl-7-anilinofluoran, 3-N-(3'ethoxypropyl)-N-ethylamino-6-methyl-7-anilinofluoran, 3-N-(2'-tetrahydrofurfuryl)-N-ethylamino-6-methyl-7-anilinofluoran, 3-N-(4'-methylphenyl)-N-ethylamino-6-methyl-7-anilinofluoran, 3-diethylamino-6-ethyl-7-anilinofluoran, 3-diethylamino-6-methyl-7-(3'-methylphenylamino) fluoran, 3-diethylamino-6-methyl-7-(2',6'-dimethylphenylamino)fluoran, 3-di-n-butylamino-6-methyl-7-(2',6'-dimethylphenylamino)fluoran, 3-di-n-butylamino-7-(2',6'-dimethylphenylamino)fluoran, 2,2-bis[4'-(3-N-cyclohexyl-N-methylamino-6-methylfluoran)-7-ylaminophenyl]propane, 3-[4'-(4-phenylaminophenyl)aminophenyl]amino-6-methyl-7-chlorofluoran, and 3-[4'(dimethylaminophenyl)]amino-5,7-dimethylfluoran,

phthalides such as 3-(2-methyl-4-diethylaminophenyl)-3-(1-ethyl-2-methylindol-3-yl)-4-azaphthalide, 3-(2-n-propoxycarbonylamino-4-di-n-propylaminophenyl)-3-(1-ethyl-2-methylindol-3-yl)-4-a zaphthalide, 3-(2-methylamino-4-di-n-propylaminophenyl)-3-(1-ethyl-2-methylindol-3-yl)-4-azaphthalide, 3-(2-methyl-4-di-n-hexylaminophenyl)-3-(1-n-octyl-2-methylindol-3-yl)-4,7-diazaphthalide, 3,3-bis(2-ethoxy-4-diethylaminophenyl)-4-azaphthalide, 3,3-bis(1-n-octyl-2-methylindol-3-yl)-4-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-octyl-2-methylindol-3-yl)-4-azaphthalide, 3-(2-ethoxy-4-diethylaminophenyl)-3-(1-octyl-2-methylindol-3-yl)-7-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-ethyl-2-methylindol-3-yl)-7-azaphthalide, 3-(2-hexyloxy-4-diethylaminophenyl)-3-(1-ethyl-2-methylindol-3-yl)-4-azaphthalide, 3-(2-hexyloxy-4-diethylaminophenyl)-3-(1-ethyl-2-methylindol-3-yl)-7-azaphthalide, 3-(2-ethoxy-4-diethylaminophenyl)-3-(1-ethyl-2-phenylindol-3-yl)-4-azaphthalide, 3-(2-ethoxy-4-diethylaminophenyl)-3-(1-ethyl-2-phenylindol-3-yl)-7-azaphthalide, 3-(2-butoxy-4-diethylaminophenyl)-3-(1-ethyl-2-phenylindol-3-yl)-4-azaphthalide, 3-(2-butoxy-4-diethylaminophenyl)-3-(1-ethyl-2-phenylindol-3-yl)-7-azaphthalide, 3-methyl-spiro-dinaphthopyran, 3-ethyl-spiro-dinaphthopyran, 3-phenyl-spiro-dinaphthopyran, 3-benzyl-spiro-dinaphthopyran, 3-methyl-naphtho-(3-methoxybenzo)spiropyran, 3-propyl-spiro-dibenzopyran-3,6-bis(dimethylamino) fluorene-9-spiro-3'-(6'-dimethylamino)p hthalide, and 3,6-bis(diethylamino)fluorene-9-spiro-3'-(6'-dimethylamino)phthalide.

Further, other examples thereof include 2-anilino-6'-(N-ethyl-N-isopentyl)amino-3'-methylspiro[isobenzofuran-1(3H),9'-(9H)xanthen e]-3-one, 2'-anilino-6'-(N-ethyl-N-(4-methylphenyl))amino-3'-methylspiro[isobenzofuran-1(3H),9'-(9H )xanthene]-3-one, 3'-N,N-dibenzylamino-6'-N,N-diethylaminospiro[isobenzofuran-1(3H),9'-(9H)xanthene]-3-o ne, and 2'-(N-methyl-N-phenyl)amino-6'-(N-ethyl-N-(4-methylphenyl))aminospiro[isobenzofuran-1( 3H),9'-(9H)xanthene]-3-one.

Among these, from the viewpoint of the color developability, it is preferable that the color developing agent used in the present disclosure is at least one compound selected from the group consisting of a spiropyran compound, a spirooxazine compound, a spirolactone compound, and a spirolactam compound.

From the viewpoint of the visibility, the hue of the dye after color development is preferably green, blue, or black.

Further, from the viewpoints of the color developability and the visibility of the exposed portion, a leuco coloring agent is preferable as the acid color developing agent.

The leuco coloring agent is not particularly limited as long as the coloring agent has a leuco structure, but the leuco coloring agent has preferably a spiro structure and more preferably a spirolactone ring structure.

Further, from the viewpoints of the color developability and the visibility of the exposed portion, a leuco coloring agent having a phthalide structure or a fluorane structure is preferable as the leuco coloring agent.

Further, from the viewpoints of the color developability and the visibility of the exposed portion, the leuco coloring agent having a phthalide structure or a fluorane structure is preferably a compound represented by any of Formulae (Le-1) to (Le-3) and more preferably a compound represented by Formula (Le-2).

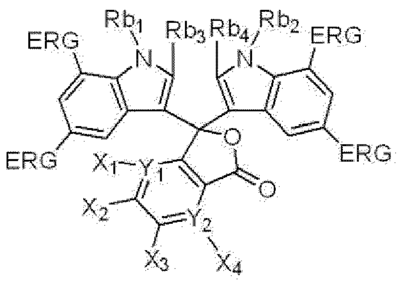
(Le - 1)

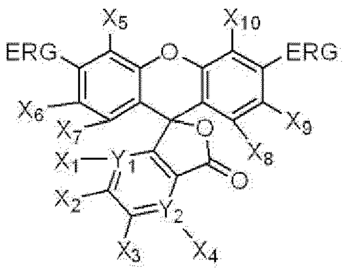
(Le - 2)

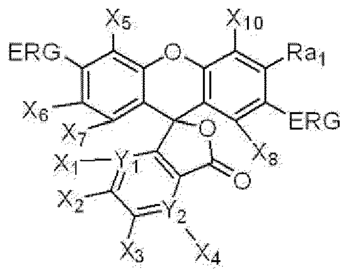
(Le - 3)

In Formulae (Le-1) to (Le-3), ERG's each independently represent an electron-donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ is not present in a case where $Y_1$ represents N, and $X_4$ is not present in a case where $Y_2$ represents N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

From the viewpoints of the color developability and the visibility of the exposed portion, as the electron-donating group represented by ERG in Formulae (Le-1) to (Le-3), an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, an alkoxy group, an aryloxy group, a heteroaryloxy group, or an alkyl group is preferable, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, an alkoxy group, or an aryloxy group is more preferable, a monoalkylmonoarylamino group, a diarylamino group, a diheteroarylamino group, or a monoarylmonoheteroarylamino group is still more preferable, and a monoalkylmonoarylamino group is particularly preferable.

Further, from the viewpoints of the color developability and the visibility of the exposed portion, as the electron-donating group represented by ERG, a disubstituted amino group that contains an aryl group having a substituent at at least one ortho position or a heteroaryl group having a substituent at at least one ortho position is preferable, a disubstituted amino group that contains a phenyl group having a substituent at at least one ortho position and an electron-donating group at the para position is more preferable, an amino group that contains a phenyl group and an aryl group or a heteroaryl group having a substituent at at least one ortho position and an electron-donating group at the para position is still more preferable, and an amino group that contains a phenyl group having a substituent at at least one ortho position and an electron-donating group at the para position, an aryl group containing an electron-donating group, or a heteroaryl g roup containing an electron-donating group is particularly preferable.

In the present disclosure, the ortho position in an aryl group or a heteroaryl group other than a phenyl group denotes a bonding position (for example, a 2-position) next to a 1-position in a case where a bonding position of the aryl group or the heteroaryl group with respect to another structure is defined as the 1-position.

Further, from the viewpoints of the color developability and the visibility of the exposed portion, as the electron-donating group contained in the aryl group or the heteroaryl group, an amino group, an alkylamino group, an arylamino

group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, an alkoxy group, an allyloxy group, a heteroaryloxy group, or an alkyl group is preferable, an alkoxy group, an aryloxy group, a heteroaryloxy group, or an alkyl group is more preferable, and an alkoxy group is still more preferable.

From the viewpoints of the color developability and the visibility of the exposed portion, $X_1$ to $X_4$ in Formulae (Le-1) to (Le-3) each independently represent preferably a hydrogen atom or a chlorine atom and more preferably a hydrogen atom.

From the viewpoints of the color developability and the visibility of the exposed portion, $X_5$ to $X_{10}$ in Formula (Le-2) or Formula (Le-3) each independently represent preferably a hydrogen atom, a halogen atom, an alkyl group, an aryl group, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, or a cyano group, more preferably a hydrogen atom, a halogen atom, an alkyl group, an aryl group, an alkoxy group, or an aryloxy group, still more preferably a hydrogen atom, a halogen atom, an alkyl group, or an aryl group, and particularly preferably a hydrogen atom.

From the viewpoints of the color developability and the visibility of the exposed portion, it is preferable that at least one of $Y_1$ or $Y_2$ in Formulae (Le-1) to (Le-3) represents C and more preferable that both $Y_1$ and $Y_2$ represent C.

From the viewpoints of the color developability and the visibility of the exposed portion, $Ra_1$ in Formulae (Le-1) to (Le-3) represents preferably an alkyl group or an alkoxy group, more preferably an alkoxy group, and still more preferably a methoxy group.

From the viewpoints of the color developability and the visibility of the exposed portion, $Rb_1$ to $Rb_4$ in Formulae (Le-1) to (Le-3) each independently represent preferably a hydrogen atom or an alkyl group, more preferably an alkyl group, and still more preferably a methyl group.

Further, from the viewpoints of the color developability and the visibility of the exposed portion, a compound represented by any of Formulae (Le-4) to (Le-6) is more preferable, and a compound represented by Formula (Le-5) is still more preferable as the leuco coloring agent having a phthalide structure or a fluorane structure.

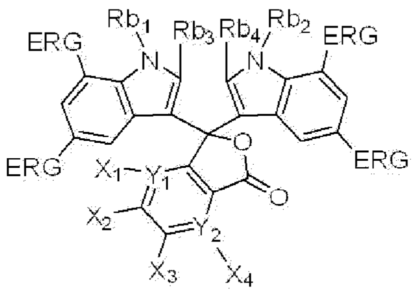
(Le-4)

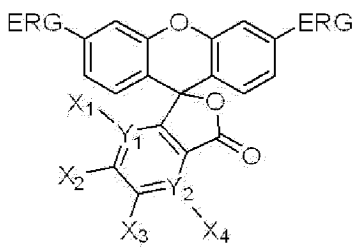
(Le-5)

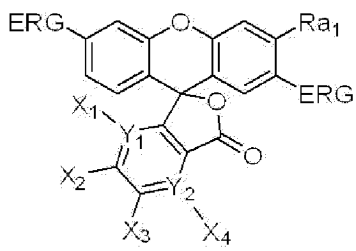
(Le-6)

In Formulae (Le-4) to (Le-6), ERG's each independently represent an electron-donating group, $X_1$ to $X_4$ each independently represent a hydrogen atom, a halogen atom, or a dialkylanilino group, $Y_1$ and $Y_2$ each independently represent C or N, $X_1$ is not present in a case where $Y_1$ represents N, and $X_4$ is not present in a case where $Y_2$ represents N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

ERG, $X_1$ to $X_4$, $Y_1$, $Y_2$, $Ra_1$, and $Rb_1$ to $Rb_4$ in Formulae (Le-4) to (Le-6) each have the same definition as that for ERG, $X_1$ to $X_4$, $Y_1$, $Y_2$, $Ra_1$, and $Rb_1$ to $Rb_4$ in Formulae (Le-1) to (Le-3), and the preferable aspects thereof are also the same as described above.

Further, from the viewpoints of the color developability and the visibility of the exposed portion, a compound represented by any of Formulae (Le-7) to (Le-9) is still more preferable, and a compound represented by Formula (Le-8) is particularly preferable as the leuco coloring agent having a phthalide structure or a fluorane structure.

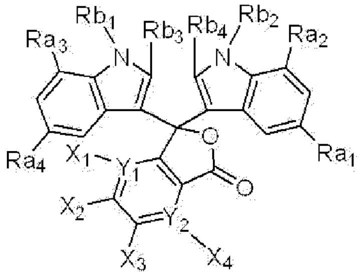
(Le-7)

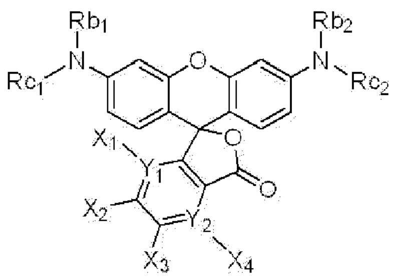
(Le-8)

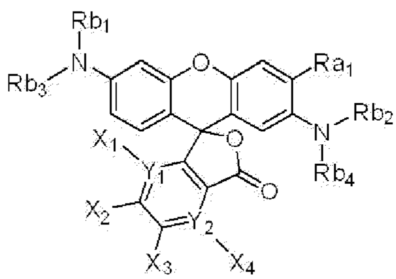
(Le-9)

In Formulae (Le-7) to (Le-9), $X_1$ to $X_4$ each independently represent a hydrogen atom, a halogen atom, or a dialkylanilino group, $Y_1$ and $Y_2$ each independently represent C or N, $X_1$ is not present in a case where $Y_1$ represents N, and $X_4$ is not present in a case where $Y_2$ represents N, $Ra_1$ to $Ra_4$ each independently represent a hydrogen atom, an alkyl group, or an alkoxy group, $Rb_1$ to $Rb_4$ each independently represent a hydrogen atom, an alkyl group, an aryl group, or a heteroaryl group, and $Rc_1$ and $Rc_2$ each independently represent an aryl group or a heteroaryl group.

$X_1$ to $X_4$, $Y_1$, and $Y_2$ in Formulae (Le-7) to (Le-9) each have the same definition as that for $X_1$ to $X_4$, $Y_1$, and $Y_2$ in Formulae (Le-1) to (Le-3), and the preferable aspects thereof are also the same as described above.

From the viewpoints of the color developability and the visibility of the exposed portion, $Ra_1$ to $Ra_4$ in Formulae (Le-7) to (Le-9) each independently represent preferably an alkyl group or an alkoxy group, more preferably an alkoxy group, and still more preferably a methoxy group.

From the viewpoints of the color developability and the visibility of the exposed portion, $Rb_1$ to $Rb_4$ in Formulae (Le-7) to (Le-9) each independently represent preferably a hydrogen atom, an alkyl group, or an aryl group substituted with an alkoxy group, more preferably an alkyl group, and still more preferably a methyl group.

From the viewpoints of the color developability and the visibility of the exposed portion, $Rc_1$ and $Rc_2$ in Formula (Le-8) each independently represent preferably a phenyl group or an alkylphenyl group and more preferably a phenyl group.

Further, from the viewpoints of the color developability and the visibility of the exposed portion, $Rc_1$ and $Rc_2$ in Formula (Le-8) each independently represent preferably an aryl group having a substituent at at least one ortho position or a heteroaryl group having a substituent at at least one ortho position, more preferably an aryl group having a substituent at at least one ortho position, still more preferably a phenyl group having a substituent at at least one ortho position, and particularly preferably a phenyl group having a substituent at at least one ortho position and an electron-donating group at the para position. Examples of the substituents in $Rc_1$ and $Rc_2$ include substituents described below.

In Formula (Le-8), from the viewpoints of the color developability and the visibility of the exposed portion, it is preferable that $X_1$ to $X_4$ represent a hydrogen atom and that $Y_1$ and $Y_2$ represent C.

Further, in Formula (Le-8), from the viewpoints of the color developability and the visibility of the exposed portion, it is preferable that $Rb_1$ and $Rb_2$ each independently represent an alkyl group or an aryl group substituted with an alkoxy group.

Further, in Formula (Le-8), from the viewpoints of the color developability and the visibility of the exposed portion, $Rb_1$ and Rb2 each independently represent preferably an aryl group or a heteroaryl group, more preferably an aryl group, still more preferably an aryl group having an electron-donating group, and particularly preferably a phenyl group having an electron-donating group at the para position.

Further, from the viewpoints of the color developability and the visibility of the exposed portion, as the electron-donating group in $Rb_1$, $Rb_2$, $Rc_1$, and $Rc_2$, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, an alkoxy group, an aryloxy group, a heteroaryloxy group, or an alkyl group is preferable, an alkoxy group, an aryloxy group, a heteroaryloxy group, or an alkyl group is more preferable, and an alkoxy group is still more preferable.

Further, from the viewpoints of the color developability and the visibility of the exposed portion, it is preferable that the image recording layer contains a compound represented by Formula (Le-10) as the acid color developing agent.

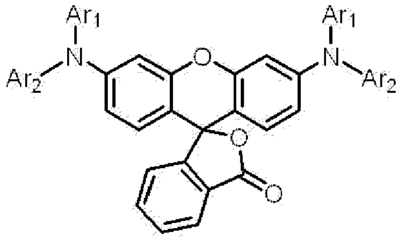

( Le - 10 )

In Formula (Le-10), $Ar_1$'s each independently represent an aryl group or a heteroaryl group, and $Ar_2$'s each independently represent an aryl group having a substituent at at least one ortho position or a heteroaryl group having a substituent at at least one ortho position.

$Ar_1$ in Formula (Le-10) has the same definition as that for $Rb_1$ and $Rb_2$ in Formulae (Le-7) to (Le-9), and the preferable aspects thereof are the same as described above.

$Ar_2$ in Formula (Le-10) has the same definition as that for $Rc_1$ and $Rc_2$ in Formulae (Le-7) to (Le-9), and the preferable aspects thereof are the same as described above.

The alkyl group in Formulae (Le-1) to (Le-9) may be linear or branched or may have a ring structure.

Further, the number of carbon atoms of the alkyl group in Formulae (Le-1) to (Le-9) is preferably in a range of 1 to 20, more preferably in a range of 1 to 8, still more preferably in a range of 1 to 4, and particularly preferably 1 or 2.

The number of carbon atoms of the aryl group in Formulae (Le-1) to (Le-10) is preferably in a range of 6 to 20, more preferably in a range of 6 to 10, and still more preferably in a range of 6 to 8.

Specific examples of the aryl group in Formulae (Le-1) to (Le-10) include a phenyl group, a naphthyl group, an anthracenyl group, and a phenanthrenyl group, which may have a substituent.

Specific examples of the heteroaryl group in Formulae (Le-1) to (Le-10) include a furyl group, a pyridyl group, a pyrimidyl group, a pyrazoyl group, and a thiophenyl group, which may have a substituent.

Further, each of the monovalent organic group, the alkyl group, the aryl group, the heteroaryl group, the dialkylanilino group, the alkylamino group, and the alkoxy group in Formulae (Le-1) to (Le-10) may have a substituent. Examples of the substituent include an alkyl group, an aryl group, a heteroaryl group, a halogen atom, an amino group, an alkylamino group, an arylamino group, a heteroarylamino group, a dialkylamino group, a monoalkylmonoarylamino group, a monoalkylmonoheteroarylamino group, a diarylamino group, a diheteroarylamino group, a monoarylmonoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, and a cyano group. Further, these substituents may be further substituted with these substituents.

Examples of the leuco coloring agent having a phthalide structure or a fluorane structure that is suitably used include the following compounds. **In** addition, Me represents a methyl group.

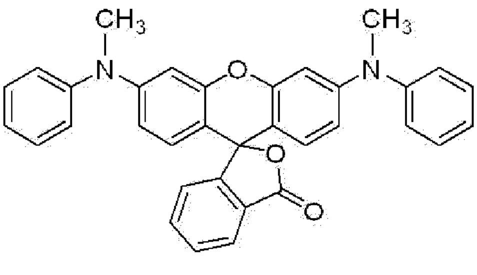

S - 1

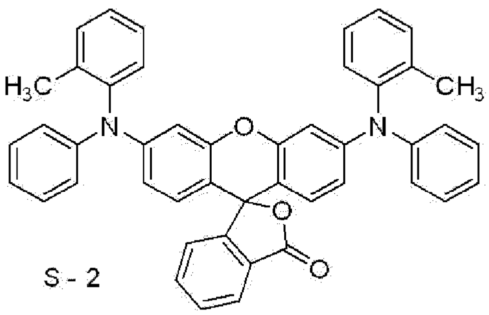

S - 2

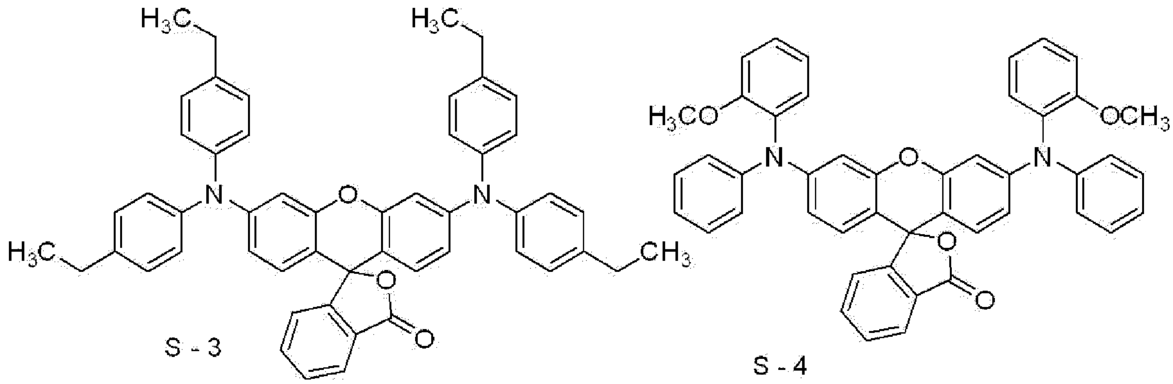

S - 3

S - 4

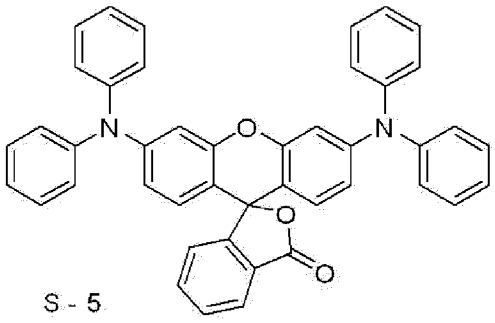

S - 5

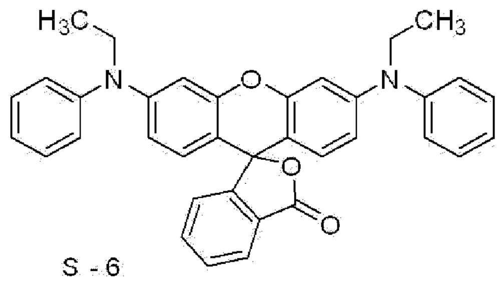

S - 6

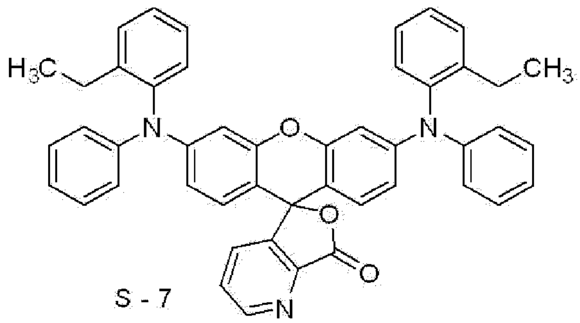

S - 7

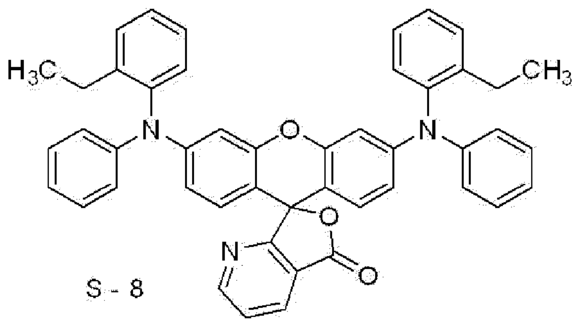

S - 8

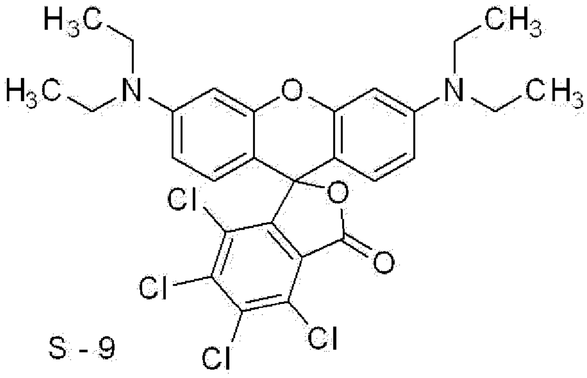

S - 9

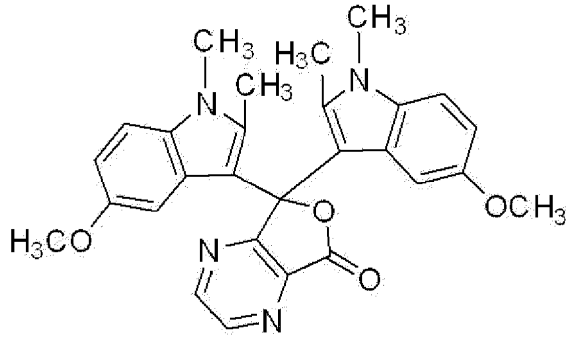

S - 10

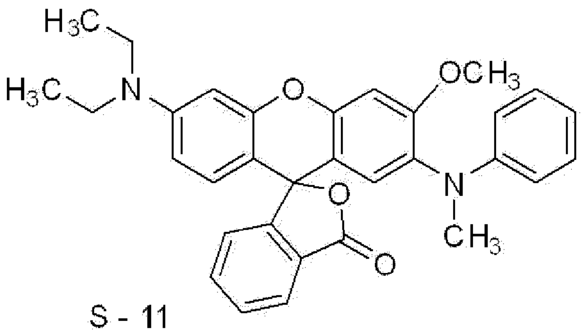

S - 11

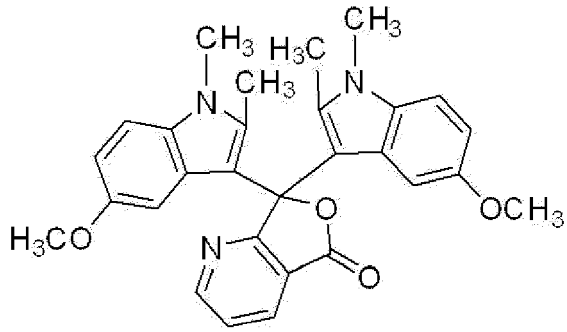

S - 12

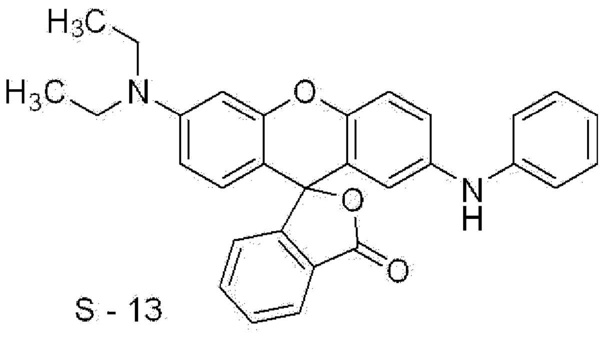

S - 13

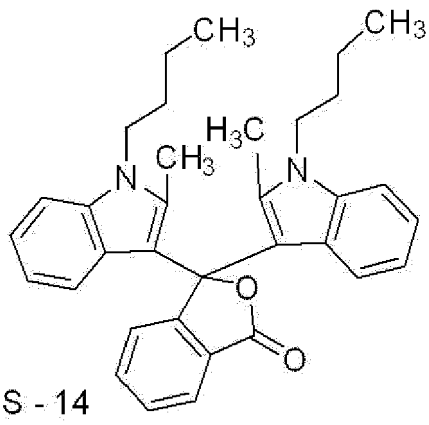

S - 14

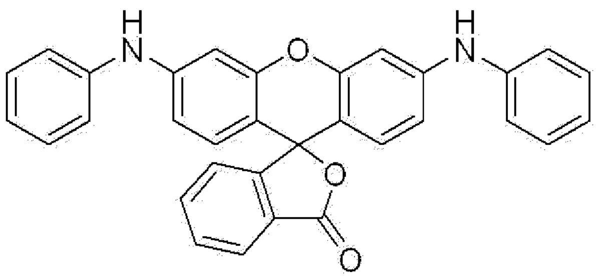

S - 15

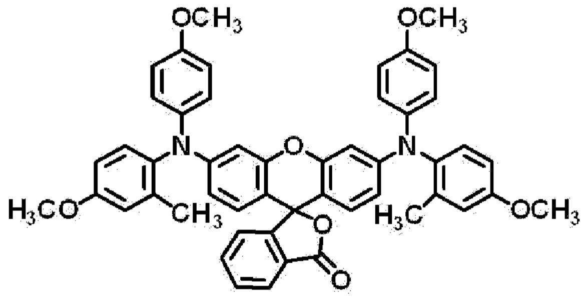

S - 16

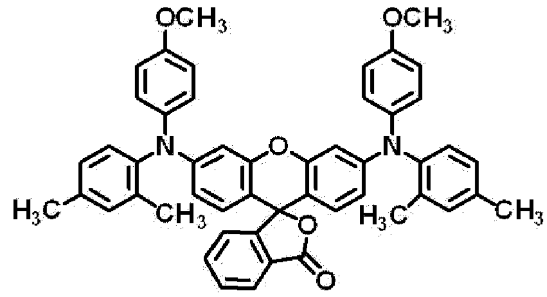

S - 17

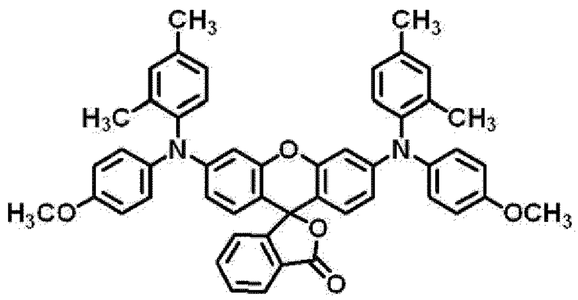

S - 18

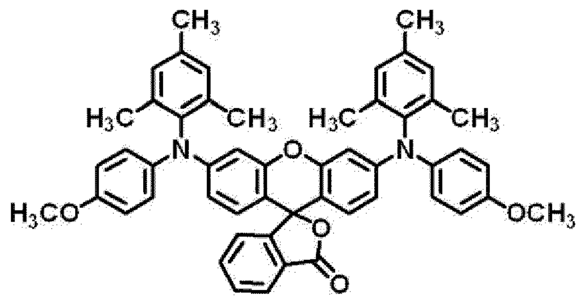

S - 19

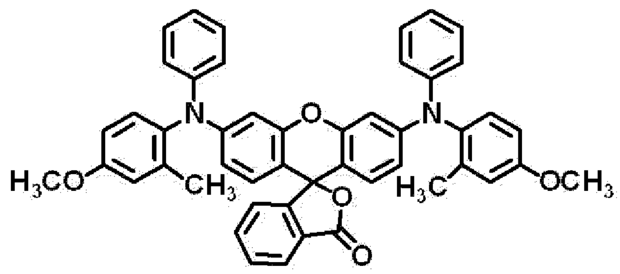

S - 20

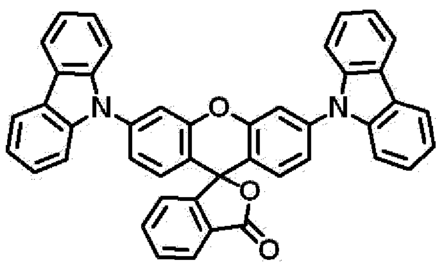

S - 21

As the acid color developing agent, a commercially available product can be used, and examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals Inc.), and Crystal Violet Lactone (manufactured by Tokyo Chemical Industry Co., Ltd.). Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and Crystal Violet Lactone are preferable from the viewpoint that the visible light absorbance of a film to be formed is satisfactory.

These color developing agents may be used alone or in combination of two or more kinds of components.

The content of the color developing agent is preferably in a range of 0.5% by mass to 10% by mass and more preferably in a range of 1% by mass to 5% by mass with respect to the total mass of the image recording layer.

The image recording layer 16 may further contain other compounds in addition to those described above as necessary.

Examples of other compounds include the coloring agent, the printing-out agent, the polymerization inhibitor, the higher fatty acid derivative, the plasticizer, the inorganic particles, and the low-molecular-weight hydrophilic compound disclosed in paragraphs [0181] to [0190] of JP2009-255434A.

Examples of other components further include the hydrophobic precursor (fine particles capable of converting an

image recording layer to be hydrophobic at the time addition of heat), the low-molecular-weight hydrophilic compound, the oil sensitizing agent (for example, a phosphonium compound, a nitrogen-containing low-molecular-weight compound, or an ammonium group-containing polymer), and the chain transfer agent disclosed in paragraphs [0191] to [0217] of JP2012-187907A.

[Other layers]

The lithographic printing plate precursor according to the embodiment of the present invention may include layers other than the aluminum support 12a, the undercoat layer 14, and the image recording layer 16 described above.
For example, for the purpose of preventing occurrence of scratches on the image recording layer 16, oxygen blocking oxygen, and preventing ablation in a case of exposure to a high illuminance laser, a protective layer may be provided on the image recording layer 16 as necessary.
Examples of the material used for the protective layer include the materials (such as a water-soluble polymer compound and an inorganic layered compound) described in paragraphs [0213] to [0227] of JP2009-255434A.

[Method of producing aluminum support]

A method of producing the aluminum support used in the lithographic printing plate precursor according to the embodiment of the present invention is not particularly limited, but it is preferable that the method includes a hydrochloric acid electrolytic treatment step of performing alternating current electrolysis on an aluminum plate in a hydrochloric acid treatment liquid which may contain sulfuric acid under the condition that the liquid temperature of the hydrochloric acid treatment liquid is 30°C or lower, a sum of the electric quantity for an anodic reaction of the aluminum plate is 400 $C/dm^2$ or less, and the peak current value of an alternating current waveform is 80$A/dm^2$ or less to prepare a roughened aluminum plate from the viewpoint of efficiently producing a predetermined aluminum support.
Further, in a case where the hydrochloric acid treatment liquid contains sulfuric acid, the ratio of the content of sulfuric acid to the content of hydrochloric acid is preferably 0.1 or less.
Further, it is preferable that the method of producing the aluminum support according to the embodiment of the present invention includes an anodization treatment step of performing an anodization treatment on the roughened aluminum plate after the hydrochloric acid electrolytic treatment step to form an anodized aluminum film on the aluminum plate.
Further, it is preferable that the method of producing the aluminum support according to the embodiment of the present invention includes a pore widening treatment step of performing an etching treatment on the aluminum plate, on which the anodized film has been formed after the anodization treatment step, to expand the diameter of micropores in the anodized film.
Hereinafter, each step described above and optional treatments will be described in detail.

<Mechanical roughening treatment>

In the method of producing the aluminum support according to the embodiment of the present invention, a mechanical roughening treatment may be performed before the hydrochloric acid electrolytic treatment step.
As a mechanical roughening treatment method, a wire brush grain method of scratching an aluminum surface with a metal wire, a ball grain method of graining an aluminum surface with a polishing ball and an abrasive, or a brush grain method of graining a surface with a nylon brush and an abrasive described in JP1994-135175A (JP-H6-135175A) and JP1975-040047B (JP-S50-040047B) can be used.

<Hydrochloric acid electrolytic treatment step>

It is preferable that the hydrochloric acid electrolytic treatment step of the method of producing the aluminum support according to the embodiment of the present invention is a hydrochloric acid electrolytic treatment step of performing alternating current electrolysis on an aluminum plate in a hydrochloric acid treatment liquid which may contain sulfuric acid under the condition that the liquid temperature of the hydrochloric acid treatment liquid is 30°C or lower, the sum of the electric quantity for an anodic reaction of the aluminum plate is 400 $C/dm^2$ or less, and the peak current value of an alternating current waveform is 80$A/dm^2$ or less to prepare a roughened aluminum plate.
In the present invention, the lithographic printing plate precursor (the first embodiment and the second embodiment of the lithographic printing plate precursor) described above can be efficiently produced by performing the above-described hydrochloric acid electrolytic treatment and the anodization treatment described below.
The hydrochloric acid treatment liquid contains hydrochloric acid, and the concentration of hydrochloric acid is preferably in a range of 5 to 30 g/L and more preferably in a range of 10 to 20 g/L.

The hydrochloric acid treatment liquid may contain sulfuric acid. In a case where the hydrochloric acid treatment liquid contains sulfuric acid, the concentration of sulfuric acid in the hydrochloric acid treatment liquid is preferably 2.0 g/L or less, more preferably 1.0 g/L or less, and still more preferably 0.5 g/L. In a case where the hydrochloric acid treatment liquid contains sulfuric acid, the lower limit of the concentration of sulfuric acid in the hydrochloric acid treatment liquid is not particularly limited and may be greater than 0 g/L.

The hydrochloric acid treatment liquid may contain aluminum ions. In a case where the hydrochloric acid treatment liquid contains aluminum ions, the concentration of the aluminum ions is preferably in a range of 1.0 to 30.0 g/L and more preferably in a range of 5.0 to 20.0 g/L.

In a case where the hydrochloric acid treatment liquid contains sulfuric acid, the ratio of the content of sulfuric acid to the content of hydrochloric acid is preferably 0.1 or less. The lower limit thereof is not particularly limited and may be greater than 0.

The liquid temperature of the hydrochloric acid treatment liquid is 30°C or lower, preferably 26°C or lower, and more preferably 23°C or lower. The lower limit thereof is not particularly limited, but is preferably 10°C or higher and more preferably 15°C or higher.

In the present invention, the sum of the electric quantity (the sum of the electric quantity for the anodic reaction of the aluminum plate at the time at which the hydrochloric acid electrolytic treatment is completed) is preferably 400 $C/dm^2$ or less and more preferably 350 $C/dm^2$ or less. The lower limit of the sum of the electric quantity is not particularly limited, but is preferably 50 $C/dm^2$ or greater and more preferably 100 $C/dm^2$ or greater.

The peak current value of the alternating current waveform is preferably 80 $A/dm^2$ or less and more preferably 70 $A/dm^2$ or less. The peak current value thereof is preferably 10 $A/dm^2$ or greater and more preferably 20 $A/dm^2$ or greater.

The alternating current waveform of the hydrochloric acid electrolytic treatment may use a sine wave, a square wave, a trapezoidal wave, a triangular wave, or the like. The frequency is preferably in a range of 0.1 to 250 Hz.

Fig. 3 is a graph showing an example of an alternating waveform current waveform diagram used for the hydrochloric acid electrolytic treatment.

In Fig. 3, ta represents an anodic reaction time, tc represents a cathodic reaction time, tp represents a time taken for the current to reach the peak from 0, Ia represents the peak current on an anode cycle side, and Ic represents the peak current on a cathode cycle side. In the trapezoidal wave, the time tp taken for the current to reach the peak from 0 is preferably in a range of 1 to 10 msec. As the preferable conditions for one cycle of the alternating current used for the hydrochloric acid electrolytic treatment, a ratio tc/ta of the cathodic reaction time tc to the anodic reaction time ta of the aluminum plate is in a range of 1 to 20, a ratio Qc/Qa of an electric quantity Qc in a case of the aluminum plate serving as an anode to an electric quantity Qa in a case of the aluminum plate serving as an anode is in a range of 0.3 to 20, and the anodic reaction time ta is in a range of 5 msec to 1,000 msec. It is preferable that the current density is in the above-described range (80 A/dm2 or less) in both the anode cycle side Ia and the cathode cycle side Ic of the current in terms of the peak value of the trapezoidal wave.

A device illustrated in Fig. 4 can be used for the hydrochloric acid electrolytic treatment carried out using the alternating current.

Fig. 4 is a side view illustrating an example of a radial type cell in the hydrochloric acid electrolytic treatment carried out using the alternating current.

In Fig. 4, 50 represents a main electrolytic cell, 51 represents an AC power source, 52 represents a radial drum roller, 53a and 53b represent a main pole, 54 represents an electrolytic solution supply port, 55 represents an electrolytic solution, 56 represents a slit, 57 represents an electrolytic solution passage, 58 represents an auxiliary anode, 60 represents an auxiliary anode cell, and W represents an aluminum plate. In a case where two or more electrolytic cells are used, the electrolysis conditions may be the same as or different from each other.

The aluminum plate W is wound around the radial drum roller 52 disposed by being immersed in the main electrolytic cell 50 and is subjected to the electrolytic treatment by the main poles 53a and 53b connected to the AC power source 51 in the transport process. The electrolytic solution 55 is supplied to the electrolytic solution passage 57 disposed between the radial drum roller 52 and the main pole 53a and between the radial drum roller 52 and the main pole 53b through the slit 56 from the electrolytic solution supply port 54. The aluminum plate W which has been treated in the main electrolytic cell 50 is electrolyzed in the auxiliary anode cell 60. The auxiliary anode 58 is disposed in the auxiliary anode cell 60 so as to face the aluminum plate W and the electrolytic solution 55 is supplied so as to flow through the space between the auxiliary anode 58 and the aluminum plate W.

<Alkali etching treatment>

In the method of producing the aluminum support according to the embodiment of the present invention, it is preferable that an alkali etching treatment is performed after the mechanical roughening treatment in a case where the above-described mechanical roughening treatment is performed and before and after the above-described hydrochloric acid electrolytic treatment step.

In addition, the alkali etching treatment performed before the hydrochloric acid electrolytic treatment is performed for the purpose of removing rolling oil, stains, natural oxide films, and the like on the surface of the aluminum base material (rolled aluminum) in a case where the mechanical roughening treatment has not been performed and for the purpose of dissolving edge portions of unevenness generated by the mechanical roughening treatment to change the surface with steep unevenness to a surface with smooth undulations in a case where the mechanical roughening treatment has been performed.

In a case where the mechanical roughening treatment is not performed before the alkali etching treatment, the etching amount is preferably in a range of 0.1 to 10 g/$m^2$ and more preferably in a range of 1 to 5 g/$m^2$. In a case where the etching amount is in a range of 1 to 10 g/$m^2$, rolling oil, stains, natural oxide films, and the like on the surface are sufficiently removed.

In a case where the mechanical roughening treatment is performed before the alkali etching treatment, the etching amount is preferably in a range of 3 to 20 g/$m^2$ and more preferably in a range of 5 to 15 g/$m^2$.

The alkali etching treatment performed immediately after the hydrochloric acid electrolytic treatment is performed for the purpose of dissolving smut generated in an acidic electrolytic solution and dissolving edge portions of unevenness formed by the hydrochloric acid electrolytic treatment. Since the unevenness formed by the hydrochloric acid electrolytic treatment varies depending on the kind of the electrolytic solution, the optimum etching amount also varies, but the etching amount in the alkali etching treatment performed after the hydrochloric acid electrolytic treatment is preferably in a range of 0 to 0.5 g/$m^2$ and more preferably in a range of 0 to 0.3 g/$m^2$.

Examples of the alkali used in the alkaline solution include caustic alkali and an alkali metal salt. In particular, an aqueous solution of caustic soda is preferable.

The concentration of the alkaline solution can be determined depending on the etching amount, but is preferably in a range of 1% to 50% by mass and more preferably in a range of 10% to 35% by mass. In a case where aluminum ions are dissolved in the alkaline solution, the concentration of the aluminum ions is preferably in a range of 0.01% to 10% by mass and more preferably in a range of 3% to 8% by mass. The temperature of the alkaline solution is preferably in a range of 20°C to 90°C. The treatment time is preferably in a range of 0 to 120 seconds.

Examples of a method of bringing the aluminum base material into contact with the alkaline solution include a method of passing the aluminum base material through a tank containing the alkaline solution, a method of immersing the aluminum base material in a tank containing the alkaline solution, and a method of spraying the alkaline solution onto the surface of the aluminum base material.

<Desmutting treatment>

In the method of producing the aluminum support according to the embodiment of the present invention, it is preferable that acid cleaning (desmutting treatment) is performed to remove corrosive organisms remaining on the surface after the hydrochloric acid electrolytic treatment or the alkali etching treatment is performed.

As the acid to be used, for example, nitric acid, sulfuric acid, hydrochloric acid, or the like is commonly used, but other acids may be used.

The desmutting treatment is performed, for example, by bringing the aluminum base material into contact with an acidic solution (containing 0.01% to 5% by mass of aluminum ions) in which the concentration of hydrochloric acid, nitric acid, sulfuric acid, or the like is in a range of 0.5% to 30% by mass.

Examples of a method of bringing the aluminum base material into contact with the acidic solution include a method of passing the aluminum base material through a tank containing the acidic solution, a method of immersing the aluminum base material in a tank containing the acidic solution, and a method of spraying the acidic solution onto the surface of the aluminum base material.

Since the surface state of the aluminum base material after the desmutting treatment affects the subsequent growth of natural oxide films, the kind of the acid, the concentration, and the temperature conditions are appropriately selected depending on the purpose.

<Water washing treatment>

In the method of producing the aluminum support according to the embodiment of the present invention, it is preferable to perform washing with water after completion of each of the treatment steps described above. In particular, washing with water at the end of the step affects the subsequent growth of natural oxide films, and thus washing with water is required to be sufficiently performed using pure water, well water, tap water, or the like.

<Anodization treatment step>

The above-described anodization treatment step is a step of performing an anodization treatment on the

roughened aluminum plate after the hydrochloric acid electrolytic treatment step to form an anodized aluminum film on the aluminum plate.

Here, the procedure of the anodization treatment step is not particularly limited, and examples thereof include known methods.

In the anodization treatment step, an aqueous solution containing sulfuric acid, phosphoric acid, oxalic acid, or the like can be used as an electrolytic cell. For example, the concentration of the sulfuric acid is in a range of 100 to 300 g/L.

The conditions for the anodization treatment are appropriately set depending on the electrolytic solution. As an example of the conditions, the liquid temperature is in a range of 5°C to 70°C (preferably in a range of 10°C to 60°C), the current density is in a range of 0.5 to 60 A/dm$^2$ (preferably in a range of 5 to 60 A/dm$^2$), the voltage is in a range of 1 to 100 V (preferably in a range of 5 to 50 V), the electrolysis time is in a range of 1 to 100 seconds (preferably in a range of 5 to 60 seconds), and the coated film amount is in a range of 0.1 to 5 g/m$^2$ (preferably in a range of 0.2 to 3 g/m$^2$).

In the present invention, from the viewpoint of further enhancing the adhesiveness between the aluminum support and the image recording layer, it is preferable that the anodization treatment step is a step of performing the anodization treatment using phosphoric acid.

<Pore widening treatment step>

The above-described pore widening treatment step is a treatment (pore diameter expanding treatment) step of performing an etching treatment on the aluminum plate, on which the anodized film has been formed after the anodization treatment step described above, to expand the diameter of micropores in the anodized film.

The pore widening treatment can be performed by bringing the aluminum plate obtained in the anodization treatment step into contact with an acid aqueous solution or an alkaline aqueous solution. The method of bringing the aluminum plate into contact with the solution is not particularly limited, and examples thereof include an immersion method and a spray method.

[Method of producing lithographic printing plate precursor]

It is preferable that the above-described method of producing the lithographic printing plate precursor according to the embodiment of the present invention is a production method of sequentially performing the following steps after the above-described method of producing the aluminum support according to the embodiment of the present invention.

(Undercoat layer forming step) A step of forming an undercoat layer on the aluminum support obtained in the pore widening treatment step

(Image recording layer forming step) A step of forming an image recording layer on the undercoat layer

Hereinafter, the procedures of each step will be described in detail.

<Undercoat layer forming step>

The undercoat layer forming step is a step of forming an undercoat layer on the aluminum support obtained in the pore widening treatment step.

The method of producing the undercoat layer is not particularly limited, and examples thereof include a method of coating the anodized film of the aluminum support with a coating solution for forming an undercoat layer which contains a predetermined compound (such as a compound having a betaine structure).

It is preferable that the coating solution for forming an undercoat layer contains a solvent. Examples of the solvent include water and an organic solvent.

Examples of the method of coating the film with the coating solution for forming an undercoat layer include various known methods. Examples of the known methods include bar coater coating, spin coating, spray coating, curtain coating, dip coating, air knife coating, blade coating, and roll coating.

The coating amount (solid content) of the undercoat layer is preferably in a range of 0.1 to 100 mg/m$^2$.

<Image recording layer forming step>

The image recording layer forming step is a step of forming an image recording layer on the undercoat layer.

The method of forming the image recording layer is not particularly limited, and examples thereof include a method of coating the undercoat layer with a coating solution for forming an image recording layer that contains a predetermined component (such as the infrared absorbing agent, the polymerization initiator, or the polymerizable compound described above).

It is preferable that the coating solution for forming an image recording layer contains a solvent. Examples of the solvent include water and an organic solvent.

Examples of the method of applying the coating solution for forming an image recording layer include the methods exemplified as the method of applying the coating solution for forming an undercoat layer.

The coating amount (solid content) of the image recording layer varies depending on the purpose thereof, but is typically preferably in a range of 0.3 to 3.0 $g/m^2$.

In a case where a protective layer is provided on the image recording layer, the method of producing the protective layer is not particularly limited, and examples thereof include a method of coating the image recording layer with a coating solution for forming a protective layer which contains a predetermined component.

In the above-described embodiment, the embodiment in which the micropores 22a in the anodized film 20a have a substantially straight tubular shape has been described, but the micropores may have another structure as long as the average diameter of the micropores in the surface of the anodized film is in a predetermined range.

For example, as illustrated in Fig. 5, the aluminum support 12b may include an aluminum plate 18 and an anodized film 20b having micropores 22b formed of large-diameter pores 24 and small-diameter pores 26.

The micropores 22b in the anodized film 20b are formed of large-diameter pores 24 extending to a position at a depth (depth D: see Fig. 5) of 10 to 1,000 nm from the surface of the anodized film and small-diameter pores 26 communicating with the bottom portions of large-diameter pores 24 and extending from a position at a depth of 20 to 2,000 nm from the communication positions.

Hereinafter, the large-diameter pores 24 and the small-diameter pores 26 will be described in detail.

The average diameter of the large-diameter pores 24 on the surface of the anodized film 20b is the same as the average diameter of the micropores 22a in the surface of the anodized film 20a described above, and is preferably in a range of 10 to 100 nm, and from the viewpoint of the balance between the stain resistance and the image visibility, the average diameter thereof is more preferably in a range of 15 to 100 nm, still more preferably in a range of 15 to 60 nm, particularly preferably in a range of 20 to 50 nm, and particularly preferably in a range of 25 to 40 nm.

The method of measuring the average diameter of the large-diameter pores 24 in the surface of the anodized film 20b is the same as the method of measuring the average diameter of the micropores 22a in the surface of the anodized film 20a.

The bottom of the large-diameter pores 24 is positioned at a depth of 10 to 1,000 nm (hereinafter, also referred to as a depth D) from the surface of the anodized film. **In** other words, the large-diameter pores 24 are pores extending from the surface of the anodized film to a position at a depth of 10 nm to 1,000 nm in the depth direction (thickness direction). The depth described above is preferably in a range of 10 to 200 nm.

Further, the depth thereof is a value obtained by capturing (at a magnification of 150,000) an image of a cross section of the anodized film 20b, measuring the depth of 25 or more large-diameter pores 24, and averaging the obtained values.

The shape of the large-diameter pores 24 is not particularly limited, and examples thereof include a substantially straight tubular shape (substantially columnar shape) and a conical shape whose diameter decreases toward the depth direction (thickness direction). Among these, a substantially straight tubular shape is preferable.

The small-diameter pores 26, as illustrated in Fig. 5, are pores communicating with the bottom portions of the large-diameter pores 24 and further extending from the communication positions to the depth direction (thickness direction).

The average diameter of the small-diameter pores 26 at the communication positions is less than the average diameter of the large-diameter pores and is preferably 13 nm or less. Further, the average diameter thereof is preferably 11 nm or less and more preferably 10 nm or less. The lower limit thereof is not particularly limited, but is 5 nm or greater in many cases.

The average diameter of small-diameter pores 26 is obtained by observing 4 sheets (N = 4) of the surfaces of the anodized film 20a using a FE-SEM at a magnification of 150,000, measuring the diameters of 50 micropores (small-diameter pores) present in an area of $400 \times 600$ $nm^2$ in the obtained four sheets of images, and averaging the values. Further, in a case where the depth of the large-diameter pores is large, the average diameter of the small-diameter pores may be acquired by cutting the upper portion (region where large-diameter pores are present) of the anodized film 20b (for example, cutting the portion by argon gas) as necessary and observing the surface of the anodized film 20b using the above-described FE-SEM.

Further, in a case where the shape of the small-diameter pores 26 is not circular, an equivalent circle diameter is used. The "equivalent circle diameter" is a diameter of a circle obtained by assuming the shape of an opening portion of a micropore as a circle having the same projected area as the projected area of the opening portion.

The bottom of the small-diameter pores 26 is in a position extending from the communication position with the large-diameter pores 24 to a depth of 20 to 2,000 nm in the depth direction. In other words, the small-diameter pores 26 are pores extending from the communication position with the large-diameter pores 24 to the depth direction (thickness direction), and the depth of the small-diameter pores 26 is in a range of 20 to 2,000 nm. Further, the depth described above

is preferably in a range of 500 to 1,500 nm.

In addition, the depth thereof is a value obtained by capturing (50,000 times) an image of a cross section of the anodized film 20b, measuring the depth of 25 or more small-diameter pores, and averaging the obtained values.

The shape of the small-diameter pores 26 is not particularly limited, and examples thereof include a substantially straight tubular shape (substantially columnar shape) and a conical shape whose diameter decreases toward the depth direction. Among these, a substantially straight tubular shape is preferable.

Further, the method of producing the aluminum support 12b is not particularly limited, but a production method of sequentially performing the following steps is preferable.

(Hydrochloric acid electrolytic treatment step) A step of performing the above-described hydrochloric acid electrolytic treatment on the aluminum plate

(First anodization treatment step) A step of anodizing the aluminum plate which has been subjected to the roughening treatment

(Pore widening treatment step) A step of widening the diameters of micropores in the anodized film by bringing the aluminum plate having the anodized film obtained in the first anodization treatment step into contact with an acid aqueous solution or an alkaline aqueous solution

(Second anodization treatment step) a step of anodizing the aluminum plate obtained by the pore widening treatment step

Hereinafter, the procedures of each step will be described in detail.

Further, the aspect of the lithographic printing plate precursor using the undercoat layer 14 has been described in Fig. 1. However, as described above, the lithographic printing plate precursor may not include the undercoat layer.

In a case where the undercoat layer is not provided, an image recording layer may be formed after a hydrophilization treatment is performed on the aluminum support.

Examples of the hydrophilization treatment include known methods described in paragraphs 0109 to 0114 of JP2005-254638A. Among the examples, it is preferable that the hydrophilization treatment is performed using a method of immersing the support in an aqueous solution of alkali metal silicate such as sodium silicate or potassium silicate or a method of coating the support with a hydrophilic vinyl polymer or a hydrophilic compound to form a hydrophilic undercoat layer.

The hydrophilization treatment using an aqueous solution of alkali metal silicate such as sodium silicate or potassium silicate can be performed according to the procedures and the methods described in US2714066A and US3181461A.

[Method of producing lithographic printing plate]

Next, a method of producing a lithographic printing plate using the lithographic printing plate precursor will be described.

The method of producing a lithographic printing plate typically includes an exposing step of imagewise-exposing (image-exposing) the lithographic printing plate precursor to form an exposed portion and an unexposed portion and a step of removing the unexposed portion of the imagewise-exposed lithographic printing plate precursor.

More specifically, according to an aspect of the method of producing a lithographic printing plate, a method of producing a lithographic printing plate which includes an exposing step of imagewise-exposing (image-exposing) the lithographic printing plate precursor to form an exposed portion and an unexposed portion and a removing step of removing the unexposed portion of the lithographic printing plate precursor using a developer with a pH of 2 to 12 is exemplified.

Further, according to another aspect of the method of producing a lithographic printing plate, a method of producing a lithographic printing plate which includes a step of imagewise-exposing (image-exposing) the lithographic printing plate precursor to form an exposed portion and an unexposed portion and an on-press developing step of supplying at least one of a printing ink or dampening water and removing the unexposed portion of the imagewise-exposed lithographic printing plate precursor on a printing press is exemplified.

Hereinafter, these embodiments will be described.

The method of producing a lithographic printing plate includes a step of imagewise-exposing (image-exposing) the lithographic printing plate precursor. The image exposure is performed by laser exposure through a transparent original picture having a line image, a halftone image, and the like or by laser beam scanning using digital data.

The wavelength of a light source is preferably in a range of 750 to 1,400 nm. In case of the light source that emits light having a wavelength of 750 to 1,400 nm, an image recording layer containing an infrared absorbing agent which is a sensitizing dye having absorption in this wavelength range is preferably used.

As the light source having a wavelength of 750 to 1,400 nm, a solid-state laser or a semiconductor laser that

radiates infrared rays is exemplified. The output of the infrared laser is preferably 100 mW or greater, the exposure time per one pixel is preferably equal to or shorter than 20 microseconds, and the irradiation energy quantity is preferably in a range of 10 to 300 $mJ/cm^2$. For the purpose of reducing the exposure time, it is preferable to use a multi-beam laser device. The exposure mechanism may be any of an internal drum system, an external drum system, and a flat bed system.

The image exposure can be performed by a known method using a plate setter. In a case of the on-press development method described below, the lithographic printing plate precursor may be image-exposed on the printing press after the lithographic printing plate precursor is mounted on the printing press.

The image-exposed lithographic printing plate precursor is subjected to a development treatment according to a method (developer treatment method) of removing the unexposed portion using a developer with a pH of 2 to 12 or a method (on-press development method) of removing the unexposed portion using at least one of a printing ink or dampening water on the printing press.

<Developer treatment method>

In the developer treatment method, the image-exposed lithographic printing plate precursor is treated by a developer with a pH of 2 to 14, and the image recording layer of the unexposed portion is removed to produce a lithographic printing plate.

As the developer, a developer with a pH of 5 to 10 which contains at least one acid group selected from the group consisting of a phosphoric acid group, a phosphonic acid group, and a phosphinic acid group and a compound (specific compound) containing one or more carboxyl groups is preferable.

In a case where the development treatment is carried out manually, a method of allowing sponge or absorbent cotton to sufficiently contain a developer, performing the treatment while rubbing the entire lithographic printing plate precursor, and sufficiently drying the developer after completion of the treatment is exemplified. In a case of an immersion treatment, a method of immersing the lithographic printing plate precursor in a tray, a deep tank, or the like containing a developer therein for approximately 60 seconds, stirring the solution, and sufficiently drying the solution while rubbing the lithographic printing plate precursor with absorbent cotton or sponge is exemplified.

It is preferable that a device capable of simplifying the structure and the steps is used in the development treatment.

In a development treatment of the related art, a protective layer is removed by the pre-water washing step, development is performed using an alkaline developer, an alkali is removed by the post-water washing step, the gum treatment is performed by a gum coating step, and drying is performed by a drying step.

**In** addition, development and gum coating can be simultaneously performed using one liquid. As the gum, a polymer is preferable, and a water-soluble polymer compound or a surfactant is more preferable.

Further, it is preferable that removal of the protective layer, development, and gum coating are simultaneously performed using one liquid without performing the pre-water washing step. Further, it is preferable that the excessive developer is removed using a squeeze roller after the development and the gum coating and then drying is performed.

The present treatment may be performed according to a method of performing immersion in a developer once or a method of performing immersion twice or more times. Among these, a method of performing immersion in the developer once or twice is preferable.

The immersion may be carried out by passing the exposed lithographic printing plate precursor through a developing tank in which the developer is stored or spraying the developer onto the plate surface of the exposed lithographic printing plate precursor using a spray or the like.

Further, the development treatment is performed using one liquid (one liquid treatment) even in a case where the printing plate precursor is immersed in the developer twice or more times or in a case where the printing plate precursor is immersed, twice or more times, in the same developer as described above or a developer (fatigue liquid) obtained by dissolving or dispersing components of the image recording layer using the developer and the development treatment.

In the development treatment, it is preferable to use a rubbing member and also preferable that a rubbing member such as a brush is installed in a developing bath which removes a non-image area of the image recording layer.

The development treatment can be performed by immersing the lithographic printing plate precursor which has been subjected to the exposure treatment and rubbing the plate surface with brushes or pumping up the treatment liquid added to an external tank using a pump, spraying the developer from a spray nozzle, and rubbing the plate surface with brushes, at a temperature of preferably in a range of 0°C to 60°C and more preferably in a range of 15°C to 40°C using a known method. These development treatments can be continuously performed plural times. For example, the development treatment can be performed by pumping up the developer added to an external tank using a pump, spraying the developer from a spray nozzle, rubbing the plate surface with brushes, spraying the developer from the spray nozzle again, and rubbing the plate surface with the brushes. In a case where the development treatment is performed using an automatic development device, since the developer becomes fatigued as the treatment amount increases, it is preferable that the treatment capability is recovered using a replenisher or a fresh developer.

The development treatment of the present disclosure can also be performed using a gum coater or an automatic development device which has been known to be used for a presensitized (PS) plate and CTP (computer to plate) in the related art. In a case where an automatic development device is used, for example, any method from among a method of performing the treatment by pumping the developer added to a developing tank or the developer added to an external tank using a pump and spraying the developer from a spray nozzle, a method of performing the treatment by immersing a printing plate in a tank filled with the developer and transporting the printing plate using a guide roller in the developer, and a so-called disposable treatment method, which is a method of performing the treatment by supplying the substantially unused developer by an amount required for each plate can be employed. In all methods, it is more preferable that a rubbing mechanism using brushes or a molleton is provided. For example, commercially available automatic development devices (Clean Out Unit C85/C125, Clean-Out Unit + C85/120, FCF 85V, FCF 125V, FCF News (manufactured by Glunz & Jensen); and Azura CX85, Azura CX125, and Azura CX150 (manufactured by AGFA GRAPHICS) can be used. In addition, a device in which a laser exposure portion and an automatic developing device portion are integrally incorporated can also be used.

<On-press development method>

In the on-press development method, printing ink and dampening water are supplied on the printing press, and the image recording layer of the non-image area is removed to produce a lithographic printing plate using the image-exposed lithographic printing plate precursor.

In other words, the lithographic printing plate precursor is image-exposed, and the lithographic printing plate precursor is directly mounted on the printing press without performing any developer treatment or the printing plate precursor is mounted on the printing press, image-exposed on the printing press, and printed by supplying printing ink and dampening water. At the initial stage of the printing, the image recording layer of the unexposed portion is dissolved or dispersed and removed by the supplied printing ink and/or dampening water in the non-image area, and thus the hydrophilic surface in the removed portion is exposed. Meanwhile, the image recording layer cured by exposure forms an oil-based ink receiving unit having a lipophilic surface in the exposed portion. Printing ink or dampening water may be initially supplied to the plate surface, but it is preferable that printing ink is supplied thereto from the viewpoint of preventing contamination due to the components of the image recording layer from which dampening water has been removed.

In this manner, the lithographic printing plate precursor is on-press developed on the printing press and used as it is for printing a plurality of sheets. That is, according to an aspect of the printing method according to the embodiment of the present invention, a printing method including an exposing step of imagewise-exposing the lithographic printing plate precursor to form an exposed portion and an unexposed portion, and a printing step of supplying at least one of printing ink or dampening water and removing the unexposed portion of the imagewise-exposed lithographic printing plate precursor on a printing press and performing printing is exemplified.

In the method of producing a lithographic printing plate from the lithographic printing plate precursor according to the embodiment of the present invention, regardless of the development method, the entire surface of the lithographic printing plate precursor may be heated before the image exposure, during the image exposure, or during the time period from the image exposure to the development treatment as necessary.

Examples

Hereinafter, the features of the present invention will be described in more detail with reference to examples and comparative examples. The materials, the used amounts, the proportions, the treatment contents, the treatment procedures, and the like shown in the examples below can be appropriately changed within a range not departing from the gist of the present invention. Therefore, the scope of the present invention should not be limitatively interpreted by the following examples.

[Production of aluminum support]

An aluminum plate (aluminum alloy plate) formed of a material 1S having a thickness of 0.3 mm was subjected to the following treatments to produce an aluminum support. Moreover, during all treatment steps, a water washing treatment was performed, and liquid cutting was performed using a nip roller after the water washing treatment.

[Example 1]

<Alkali etching treatment>

The aluminum plate was subjected to an etching treatment by spraying a caustic soda aqueous solution in which

the concentration of caustic soda was 26% by mass and the concentration of aluminum ions was 6.5% by mass using a spray at a temperature of 70°C. Thereafter, the aluminum plate was washed with water using a spray. The amount of aluminum dissolved in the surface to be subsequently subjected to an electrochemical roughening treatment was 5 g/$m^2$.

<Desmutting treatment using acidic aqueous solution>

Next, a desmutting treatment was performed using an acidic aqueous solution. Specifically, the desmutting treatment was performed by spraying the acidic aqueous solution to the aluminum plate for 3 seconds using a spray. As the acidic aqueous solution used for the desmutting treatment, an aqueous solution containing 150 g/L of sulfuric acid was used. The liquid temperature was 30°C.

<Electrochemical roughening treatment>

Next, an electrochemical roughening treatment was performed using the alternating current and an electrolytic solution having a hydrochloric acid concentration of 13 g/L, an aluminum ion concentration of 15 g/L, and a sulfuric acid concentration of 1.0 g/L. The liquid temperature of the electrolytic solution was 25°C. The aluminum ion concentration was adjusted by adding aluminum chloride.

The waveform of the alternating current was a sine wave in which the positive and negative waveforms were symmetrical, the frequency was 50 Hz, the ratio between the anodic reaction time and the cathodic reaction time in one cycle of the alternating current was 1: 1, and the current density was 35 A/$dm^2$ in terms of the peak current value of the alternating current waveform. Further, the sum of the electric quantity for the anodic reaction of the aluminum plate was 300 C/$dm^2$, and the electrolytic treatment was performed four times at energization intervals of 2.5 seconds for each electric quantity of 75 C/$dm^2$. A carbon electrode was used as a counter electrode of the aluminum plate. Thereafter, a water washing treatment was performed.

<Alkali etching treatment>

The aluminum plate after being subjected to the electrochemical roughening treatment was subjected to an etching treatment by spraying a caustic soda aqueous solution in which the concentration of caustic soda was 5% by mass and the concentration of aluminum ions was 0.5% by mass using a spray at a temperature of 45°C. The amount of aluminum dissolved in the surface after being subjected to an electrochemical roughening treatment was 0.2 g/$m^2$. Thereafter, a water washing treatment was performed.

<Desmutting treatment using acidic aqueous solution>

Next, a desmutting treatment was performed using an acidic aqueous solution. Specifically, the desmutting treatment was performed by spraying the acidic aqueous solution to the aluminum plate for 3 seconds using a spray. As the acidic aqueous solution used for the desmutting treatment, an aqueous solution having a sulfuric acid concentration of 170 g/L and an aluminum ion concentration of 5 g/L was used. The liquid temperature was 35°C.

<First stage anodization treatment>

A first-stage anodization treatment was performed by an anodization device having a structure illustrated in Fig. 6 using direct current electrolysis. The anodization treatment was performed using an electrolytic solution (aqueous solution) containing sulfuric acid under the conditions listed in Table 1 to form an anodized film having a predetermined film thickness. In addition, the column of "concentration (g/L) of electrolytic solution" in Table 1 denotes the concentration of sulfuric acid.

In an anodization treatment device 610 illustrated in Fig. 6, an aluminum plate 616 is transported as indicated by the arrow in Fig. 6. The aluminum plate 616 is positively (+) charged by a power supply electrode 620 in a power supply tank 612 in which an electrolytic solution 618 is stored. Further, the aluminum plate 616 is transported upward by a roller 622 in the power supply tank 612, redirected downward by a nip roller 624, transported toward an electrolytic treatment tank 614 in which an electrolytic solution 626 is stored, and redirected to the horizontal direction by a roller 628. Next, the aluminum plate 616 is negatively (-) charged by an electrolytic electrode 630 so that an anodized film is formed on the surface thereof, and the aluminum plate 616 coming out of the electrolytic treatment tank 614 is transported to the next step. In the anodization device 610, direction changing means is formed of the roller 622, the nip roller 624, and the roller 628. The aluminum plate 616 is transported in a mountain shape and an inverted U shape by the roller 622, the nip roller 624, and the roller 628 in an inter-tank portion between the power supply tank 612 and the electrolytic treatment tank 614. The power supply electrode 620 and the electrolytic electrode 630 are connected to a DC power source 634. A tank wall 632 is

disposed between the power supply tank 612 and the electrolytic treatment tank 614.

<Pore widening treatment>

The aluminum plate after being subjected to the anodization treatment was subjected to a pore widening treatment by being immersed in a caustic soda aqueous solution having a caustic soda concentration of 5% by mass and an aluminum ion concentration of 0.5% by mass at a temperature of 40°C. Thereafter, the aluminum plate was washed with water using a spray.

<Second stage anodization treatment>

A second-stage anodization treatment was performed by an anodization device having a structure illustrated in Fig. 6 using direct current electrolysis. An anodization treatment was performed using an electrolytic solution (aqueous solution) containing sulfuric acid under the conditions listed in Table 1 to form an anodized film having a predetermined film thickness, thereby preparing an aluminum support. In addition, the column of "concentration (g/L) of electrolytic solution" in Table 1 denotes the concentration of sulfuric acid.

<Examples 2 to 35 and Comparative Examples 1 to 4>

Each aluminum support was prepared by the same procedure as in Example 1 except that the liquid temperature of the electrolytic solution, the peak current value of the alternating current waveform as the current density, the sum of the electric quantity, the conditions of the anodization treatment, and the conditions of the pore widening treatment in <electrochemical roughening treatment> in Example 1 were changed as listed in Table 1.

[Table 1]

| | Conditions for hydrochloric acid electrolysis | | | | First anodization treatment | | | | Pore widening treatment | | Second anodization treatment | | | |
|---|---|---|---|---|---|---|---|---|---|---|---|---|---|---|
| | Temperature of hydrochloric acid liquid (°C) | Concentration of sulfuric acid (g/L) | Peak current ($A/dm^2$) | Electric quantity for anode ($c/dm^2$) | Electrolytic solution (g/l) | Temperature (°C) | Current density ($A/dm^2$) | Coated film amount ($g/m^2$) | Temperature (°C) | Time (sec) | Electrolytic solution (g/l) | Temperature (°C) | Current density ($A/dm^2$) | Coated film amount ($g/m^2$) |
| Example 1 | 25 | 1 | 35 | 300 | 150 | 50 | 15 | 0.2 | 30 | 5 | 150 | 50 | 30 | 3.4 |
| Example 2 | 22 | 1 | 35 | 300 | 150 | 50 | 15 | 0.2 | 30 | 5 | 150 | 50 | 30 | 3.4 |
| Example 3 | 17 | 1 | 35 | 300 | 150 | 50 | 15 | 0.2 | 30 | 5 | 150 | 50 | 30 | 3.4 |
| Example 4 | 10 | 1 | 35 | 300 | 150 | 50 | 15 | 0.2 | 30 | 5 | 150 | 50 | 30 | 3.4 |
| Example 5 | 17 | 1 | 20 | 250 | 150 | 50 | 15 | 0.2 | 30 | 5 | 150 | 50 | 30 | 3.4 |
| Example 6 | 10 | 1 | 20 | 250 | 150 | 50 | 15 | 0.2 | 30 | 5 | 150 | 50 | 30 | 3.4 |
| Example 7 | 27 | 1 | 35 | 300 | 150 | 50 | 15 | 0.2 | 30 | 5 | 150 | 50 | 30 | 3.4 |
| Example 8 | 20 | 1 | 35 | 350 | 150 | 50 | 15 | 0.2 | 30 | 5 | 150 | 50 | 30 | 3.4 |
| Example 9 | 20 | 1 | 18 | 300 | 150 | 50 | 15 | 0.2 | 30 | 5 | 150 | 50 | 30 | 3.4 |
| Example 10 | 20 | 1 | 10 | 250 | 150 | 50 | 15 | 0.2 | 30 | 5 | 150 | 50 | 30 | 3.4 |
| Example 11 | 17 | 0.5 | 35 | 300 | 150 | 50 | 15 | 0.2 | 30 | 5 | 150 | 50 | 30 | 3.4 |
| Example 12 | 26 | 0 | 35 | 300 | 150 | 50 | 15 | 0.2 | 30 | 5 | 150 | 50 | 30 | 3.4 |
| Example 13 | 20 | 0 | 35 | 300 | 150 | 50 | 15 | 0.2 | 30 | 5 | 150 | 50 | 30 | 3.4 |
| Example 14 | 17 | 0 | 35 | 300 | 150 | 50 | 15 | 0.2 | 30 | 5 | 150 | 50 | 30 | 3.4 |
| Example 15 | 20 | 0 | 18 | 300 | 150 | 50 | 15 | 0.2 | 30 | 5 | 150 | 50 | 30 | 3.4 |
| Example 16 | 22 | 0 | 18 | 300 | 150 | 50 | 15 | 0.2 | 30 | 5 | 150 | 50 | 30 | 3.4 |
| Example 17 | 24 | 0 | 18 | 300 | 150 | 50 | 15 | 0.2 | 30 | 5 | 150 | 50 | 30 | 3.4 |
| Example 18 | 26 | 0 | 18 | 300 | 150 | 50 | 15 | 0.2 | 30 | 5 | 150 | 50 | 30 | 3.4 |
| Example 19 | 28 | 0.5 0 | 18 | 300 | 150 | 50 | 15 | 0.2 | 30 | 5 | 150 | 50 | 30 | 3.4 |
| Example 20 | 20 | 0 | 18 | 270 | 150 | 50 | 15 | 0.2 | 30 | 5 | 150 | 50 | 30 | 3.4 |
| Example 21 | 22 | 0 | 18 | 270 | 150 | 50 | 15 | 0.2 | 30 | 5 | 150 | 50 | 30 | 3.4 |
| Example 22 | 24 | 0 | 18 | 270 | 150 | 50 | 15 | 0.2 | 30 | 5 | 150 | 50 | 30 | 3.4 |
| Example 23 | 26 | 0 | 18 | 270 | 150 | 50 | 15 | 0.2 | 30 | 5 | 150 | 50 | 30 | 3.4 |

(continued)

| | Conditions for hydrochloric acid electrolysis | | | | First anodization treatment | | | | Pore widening treatment | | Second anodization treatment | | | |
|---|---|---|---|---|---|---|---|---|---|---|---|---|---|---|
| | Temperature of hydrochloric acid liquid (°C) | Concentration of sulfuric acid (g/L) | Peak current (A/dm²) | Electric quantity for anode (c/dm²) | Electrolytic solution (g/l) | Temperature (°C) | Current density (A/dm²) | Coated film amount (g/m²) | Temperature (°C) | Time (sec) | Electrolytic solution (g/l) | Temperature (°C) | Current density (A/dm²) | Coated film amount (g/m²) |
| Example 24 | 20 | 0 | 18 | 300 | 150 | 50 | 15 | 0.2 | 30 | 5 | 150 | 50 | 30 | 3.4 |
| Example 25 | 26 | 0 | 18 | 300 | 150 | 50 | 15 | 0.2 | 30 | 5 | 150 | 50 | 30 | 3.4 |
| Example 26 | 20 | 0 | 18 | 270 | 150 | 50 | 15 | 0.2 | 30 | 5 | 150 | 50 | 30 | 3.4 |
| Example 27 | 26 | 0 | 18 | 270 | 150 | 50 | 15 | 0.2 | 30 | 5 | 150 | 50 | 30 | 3.4 |
| Example 28 | 20 | 0 | 18 | 300 | 150 | 50 | 15 | 0.2 | 30 | 5 | 150 | 50 | 30 | 3.4 |
| Example 29 | 26 | 0 | 18 | 300 | 150 | 50 | 15 | 0.2 | 30 | 5 | 150 | 50 | 30 | 3.4 |
| Example 30 | 20 | 0 | 18 | 270 | 150 | 50 | 15 | 0.2 | 30 | 5 | 150 | 50 | 30 | 3.4 |
| Example 31 | 26 | 0 | 18 | 270 | 150 | 50 | 15 | 0.2 | 30 | 5 | 150 | 50 | 30 | 3.4 |
| Example 32 | 20 | 0 | 18 | 300 | 150 | 50 | 15 | 0.2 | 30 | 5 | 150 | 50 | 30 | 3.4 |
| Example 33 | 26 | 0 | 18 | 300 | 150 | 50 | 15 | 0.2 | 30 | 5 | 150 | 50 | 30 | 3.4 |
| Example 34 | 20 | 0 | 18 | 270 | 150 | 50 | 15 | 0.2 | 30 | 5 | 150 | 50 | 30 | 3.4 |
| Example 35 | 26 | 0 | 18 | 270 | 150 | 50 | 15 | 0.2 | 30 | 5 | 150 | 50 | 30 | 3.4 |
| Comparative Example 1 | 35 | 1 | 70 | 450 | 150 | 50 | 15 | 0.2 | 30 | 5 | 150 | 50 | 30 | 3.4 |
| Comparative Example 2 | 25 | 1 | 70 | 450 | 150 | 50 | 15 | 0.2 | 30 | 5 | 150 | 50 | 30 | 3.4 |
| Comparative Example 3 | 35 | 1 | 70 | 350 | 150 | 50 | 15 | 0.2 | 30 | 5 | 150 | 50 | 30 | 3.4 |
| Comparative Example 4 | 40 | 1 | 70 | 500 | 150 | 50 | 15 | 0.2 | 30 | 5 | 150 | 50 | 30 | 3.4 |

The density of the first specific recesses, the density of the second specific recesses, the area ratio of the specific projections, the surface area ratio ΔS, and the value of the surface roughness Ra in the surface of the anodized film on a side opposite to the side of the aluminum plate in the prepared aluminum support were measured by the above-described methods. These results are listed in Table 3.

In addition, the average diameter (surface layer average diameter) of large-diameter pores in the surface of the anodized film having micropores, the average diameter (internal average diameter) of small-diameter pores at communication positions, and the depths of the large-diameter pores and the small-diameter pores in the prepared aluminum support were measured by the above-described methods. These results are listed in Table 3.

An undercoat layer was formed on the surface of the anodized film of each aluminum support prepared above using any of the following undercoat layer coating solutions 1 to 3, and an image recording layer was formed on the formed undercoat layer using any of the following image recording layer coating solutions 1 to 3.

The combination of the undercoat layer coating solution and the image recording layer coating solution used are as listed in Table 2. As listed in Table 2, a coating layer was further formed on the image recording layer using a protective layer coating solution in a case of formulations B to D.

The formulations used in each example and each comparative example are listed in Table 3.

The columns "undercoat layer coating solution" of Table 2 denote the kind of the undercoat layer coating solution used, "1" denotes an undercoat layer coating solution 1, "2" denotes an undercoat layer coating solution 2, and "3" denotes an undercoat layer coating solution 3.

The columns "image recording layer coating solution" of Table 2 denote the kind of the image recording layer coating solution used, "1" denotes an image recording layer coating solution 1, "2" denotes an image recording layer coating solution 2, and "3" denotes an image recording layer coating solution 3.

The columns "protective layer coating solution" of Table 2 denote the kind of the protective layer coating solution used, "1" denotes a protective layer coating solution 1, and "-" denotes that the protective layer coating solution was not used.

For example, the formulation A was employed in Example 1 as listed in Table 3, and the formulation A denotes that an undercoat layer was formed of the undercoat layer coating solution 1 and an image recording layer was formed of the image recording layer coating solution 1 as listed in Table 2.

The procedure for forming each layer will be described in detail below.

[Table 2]

| | Undercoat layer coating solution | Image recording layer coating solution | Protective layer coating solution |
|---|---|---|---|
| Formulation A | 1 | 1 | - |
| Formulation B | 2 | 2 | 1 |
| Formulation C | 3 | 2 | 1 |
| Formulation D | 2 | 3 | 1 |

[Formation of undercoat layer]

The surface of the anodized film of each aluminum support prepared above was coated with any of the undercoat layer coating solutions 1 to 3 such that the dry coating amount was set to 100 mg/$m^2$, thereby forming an undercoat layer.

(Undercoat layer coating solution 1)

The following components were mixed to prepare an undercoat layer coating solution 1.

· Compound for undercoat layer (P-1 shown below, 11 mass% aqueous solution): 0.10502 parts by mass
· Sodium gluconate: 0.07000 parts by mass
· Surfactant (EMALEX 710, manufactured by Nihon Emulsion Co., Ltd.): 0.00159 parts by mass
· Preservative (BIOHOPE L, manufactured by K·I Chemical Industry Co., Ltd.): 0.00149 parts by mass
· Water: 2.87190 parts by mass

P-1 (hereinafter, see structural formula)

(P-1)

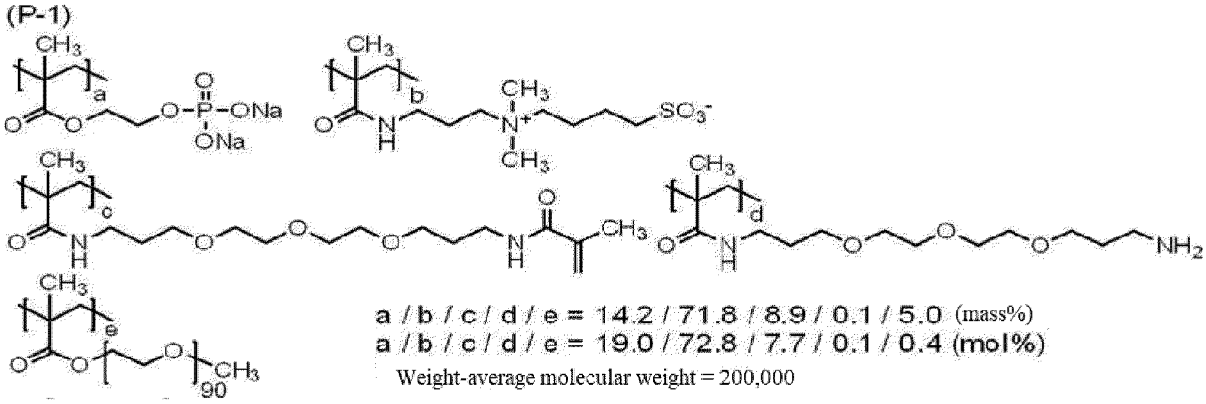


(Undercoat layer coating solution 2)

The following components were mixed to prepare an undercoat layer coating solution 2.

· Compound for undercoat layer (P-1 shown above, 11 mass% aqueous solution): 0.0788 parts by mass
· Hydroxyethyldiiminodiacetic acid: 0.0280 parts by mass
· Ethylenediaminetetraacetic acid sodium tetrahydrate: 0.0499 parts by mass
· Surfactant (MALEX (registered trademark) 710, manufactured by Nihon Emulsion Co., Ltd.): 0.0016 parts by mass
· Preservative (BIOHOPE L, manufactured by K·I Chemical Industry Co., Ltd.): 0.0015 parts by mass
· Water: 2.8701 parts by mass

(Undercoat layer coating solution 3)

The following components were mixed to prepare an undercoat layer coating solution 3.

· Compound for undercoat layer (P-1 shown above, 11 mass% aqueous solution): 0.0788 parts by mass
· Sodium gluconate: 0.0700 parts by mass
· Surfactant (MALEX (registered trademark) 710, manufactured by Nihon Emulsion Co., Ltd.): 0.0016 parts by mass
· Preservative (BIOHOPE L, manufactured by K·I Chemical Industry Co., Ltd.): 0.0015 parts by mass
· Water: 2.8780 parts by mass

[Formation of image recording layer]

The undercoat layer of the aluminum support on which the undercoat layer had been formed was bar-coated with any of the image recording layer coating solutions 1 to 3 and dried in an oven at 120°C for 40 seconds to form an image recording layer having a dry coating amount of 1.3 g/$m^2$, thereby obtaining a lithographic printing plate precursor.

(Image recording layer coating solution 1)

The following components were mixed to prepare an image recording layer coating solution 1.

· Infrared absorber (IR-1): 0.02000 parts by mass
· Color developing agent (S-1): 0.02500 parts by mass
· Electron-accepting polymerization initiator (Int-1): 0.11000 parts by mass
· Electron-donating polymerization initiator (TPB): 0.02500 parts by mass
· Polymerizable compound (M-1): 0.27500 parts by mass
· Anionic surfactant (A-1): 0.00600 parts by mass
· Fluorine-based surfactant (W-1): 0.00416 parts by mass
· 2-Butanone: 4.3602 parts by mass
· 1-Methoxy-2-propanol: 4.4852 parts by mass
· Methanol: 2.2838 parts by mass
· Microgel solution 1: 2.3256 parts by mass

IR-1

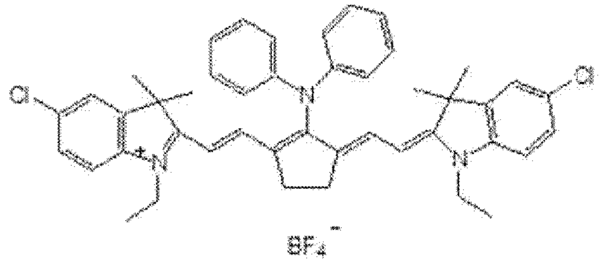

S-1

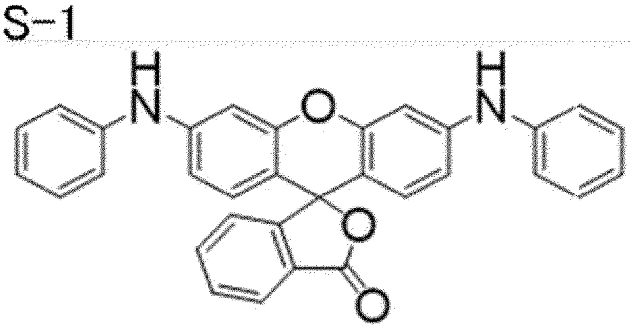

Int-1

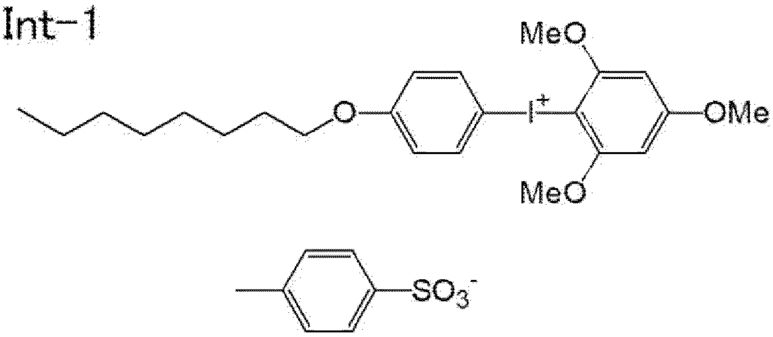

TPB

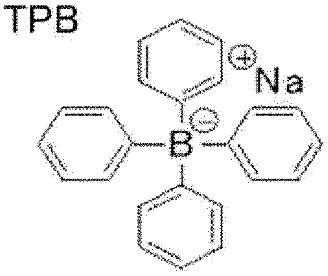

A-1

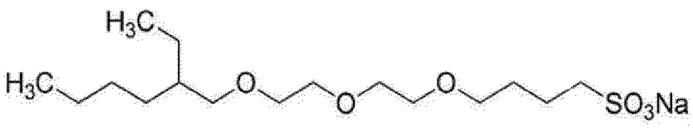

W-1

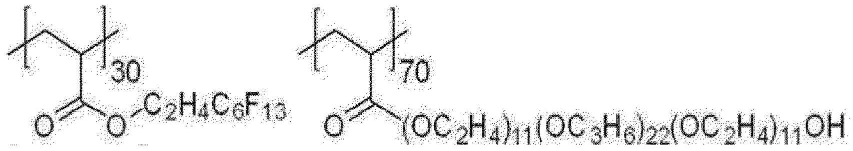

W - 1
Mw = 13,000

[Method of synthesizing polymerizable compound M-1]

A mixed solution of TAKENATE D-160N (polyisocyanate trimethylolpropane adduct, manufactured by Mitsui Chemicals, Inc., 4.7 parts), ARONIX M-403 (manufactured by Toagosei Co., Ltd., the amount was set such that the NCO value of TAKENATE D-160N and the hydroxyl value of ARONIX M-403 reached 1:1), t-butylbenzoquinone (0.02 parts), and methyl ethyl ketone (11.5 parts) was heated to 65°C. NEOSTANN U-600 (bismuth-based polycondensation catalyst, manufactured by Nitto Kasei Co., Ltd., 0.11 part) was added to the reaction solution, and the solution was heated at 65°C for 4 hours. The reaction solution was cooled to room temperature (25°C), and methyl ethyl ketone was added to synthesize a solution of urethane acrylate (corresponding to a polymerizable compound M-1) having a solid content of 50% by mass. Molecular weight fraction of the urethane acrylate solution was performed in an eluent of tetrahydrofuran (THF) using recycling type GPC (equipment: LC908-C60, column: JAIGEL-1H-40 and 2H-40 (manufactured by Japan Analytical Industry Co., Ltd.)). The weight-average molecular weight thereof was 20,000.

[Method of synthesizing microgel solution 1]

A microgel 1 was synthesized by the following procedures.

(Preparation of polyvalent isocyanate compound)

Bismuth tris(2-ethylhexanoate) (NEOSTANN U-600 (manufactured by Nitto Kasei Co., Ltd., 0.043 parts by mass) was added to a suspension solution containing ethyl acetate (25.31 parts by mass) of isophorone diisocyanate (17.78 parts by mass, 80 molar equivalents) and the following polyhydric phenol compound (1) (7.35 parts by mass, 20 molar equivalents), and the solution was stirred. The reaction temperature was set to 50° in a case of heat generation being subsided, and the solution was stirred for 3 hours, thereby obtaining an ethyl acetate (50% by mass) solution of a polyvalent isocyanate compound (1).

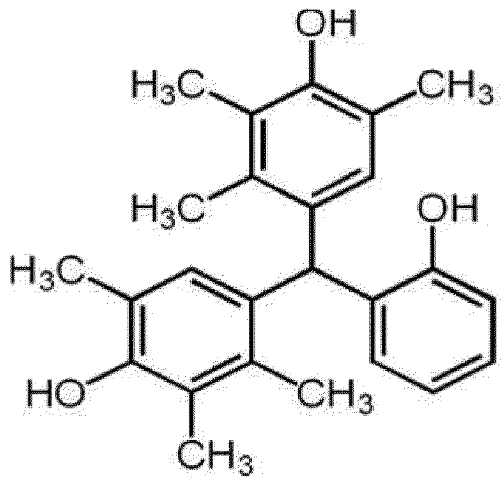

Polyhydric phenol compound (1)

(Preparation of microgel)

The oil phase components and the water phase components were mixed with each other and emulsified at 12,000 rpm for 10 minutes using a homogenizer. The obtained emulsion was stirred at 45°C for 4 hours, a 10 mass% aqueous solution (5.20 g) of 1,8-diazabicyclo[5.4.0]undeca-7-ene-octylate (U-CAT SA102, manufactured by San-Apro

Ltd.) was added thereto, and the solution was stirred at room temperature for 30 minutes and allowed to stand at 45°C for 24 hours. The concentration of solid contents was adjusted to 20% by mass using distilled water, thereby obtaining a microgel solution 1. The average particle diameter thereof was measured by the light scattering method, and the value was 0.28 μm.

- Oil phase component -

· (Component 1) ethyl acetate: 12.0 parts by mass
· (Component 2) adduct (50 mass% ethyl acetate solution, manufactured by Mitsui Chemicals, Inc.) obtained by adding trimethylolpropane (6 molar equivalents) and xylene diisocyanate (18 molar equivalents) and adding one-terminal methylated polyoxyethylene (1 molar equivalent, repetition number of oxyethylene units: 90) thereto: 3.76 parts by mass
· (Component 3) polyvalent isocyanate compound (1) (as 50 mass% ethyl acetate solution): 15.0 parts by mass
· (Component 4) 65 mass% ethyl acetate solution of dipentaerythritol pentaacrylate (SR-399, manufactured by Sartomer Japan Inc.): 11.54 parts by mass
· (Component 5) 10% ethyl acetate solution of sulfonate type surfactant (PIONINE A-41-C, manufactured by TAKEMOTO OIL & FAT Co., Ltd.): 4.42 parts by mass

- Water phase component -

· Distilled water: 46.87 parts by mass

(Image recording layer coating solution 2)

The following components were mixed to prepare an image recording layer coating solution 2.

· Infrared absorbing agent (IR-1): 0.0203 parts by mass
· Infrared absorbing agent (IR-2): 0.0068 parts by mass
· Color developing agent (S-2): 0.0120 parts by mass
· Color developing agent (S-3): 0.0300 parts by mass
· Electron-accepting polymerization initiator (Int-1): 0.0981 parts by mass
· Electron-donating polymerization initiator (TPB): 0.0270 parts by mass
· Polymerizable compound (M-2): 0.3536 parts by mass
· Tricresyl phosphate: 0.0450 parts by mass
· Anionic surfactant (A-1): 0.0162 parts by mass
· Fluorine-based surfactant (W-1): 0.0042 parts by mass
· 2-Butanone: 5.3155 parts by mass
· 1-Methoxy-2-propanol: 2.8825 parts by mass
· Methanol: 2.3391 parts by mass
· Microgel solution 2: 2.8779 parts by mass

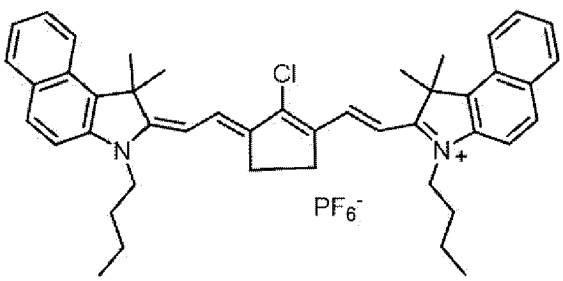

IR-2

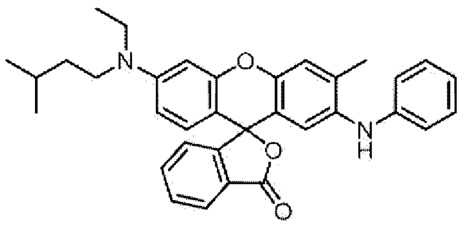

S-2

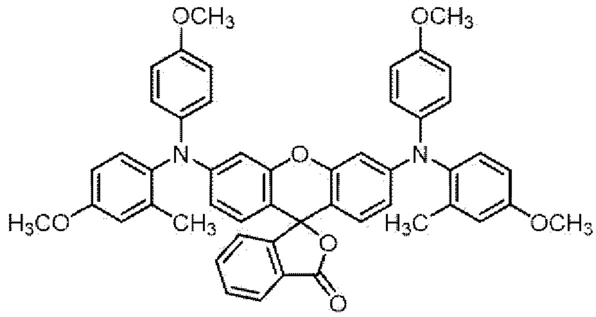

S-3

[Method of synthesizing polymerizable compound (M-2)]

A mixed solution of TAKENATE D-160N (polyisocyanate trimethylolpropane adduct, manufactured by Mitsui Chemicals, Inc., 4.7 parts by mass), ARONIX M-403 (manufactured by Toagosei Co., Ltd., the amount was set such that the NCO value of TAKENATE D-160N and the hydroxyl value of ARONIX M-403 reached 1:1), t-butylbenzoquinone (0.02 parts by mass), and methyl ethyl ketone (11.5 parts by mass) was heated to 65°C. NEOSTANN U-600 (bismuth-based polycondensation catalyst, manufactured by Nitto Kasei Co., Ltd., 0.11 part by mass) was added to the reaction solution, and the solution was heated at 65°C for 4 hours. The reaction solution was cooled to room temperature (25°C), and methyl ethyl ketone was added to synthesize a solution of a polymerizable compound (M-2) which was urethane acrylate having a solid content of 50% by mass. Molecular weight fraction of the polymerizable compound (M-2) solution was performed in an eluent of tetrahydrofuran (THF) using recycling type GPC (equipment: LC908-C60, column: JAIGEL-1H-40 and 2H-40 (manufactured by Japan Analytical Industry Co., Ltd.)). The weight-average molecular weight thereof was 20,000.

[Method of synthesizing microgel solution 2]

- Preparation of oil phase component -

6.66 g of a polyfunctional isocyanate compound (PM-200: manufactured by Wanhua Chemical Group Co., Ltd.), 5.46 g of a 50 mass% ethyl acetate solution of "TAKENATE (registered trademark) D-116N (manufactured by Mitsui Chemicals, Inc., adduct (structure shown below) of trimethylolpropane (TMP), m-xylylene diisocyanate (XDI), polyethylene glycol monomethyl ether (EO90))", 11.24 g of a 65 mass% ethyl acetate solution of dipentaerythritol pentaacrylate (SR-399, manufactured by Sartomer Japan Inc.), 14.47 g of ethyl acetate, and 0.45 g of PIONIN (registered trademark) A-41-C (manufactured by TAKEMOTO OIL & FAT Co., Ltd.) were mixed and stirred at room temperature (25°C) for 15 minutes, thereby obtaining an oil phase component.

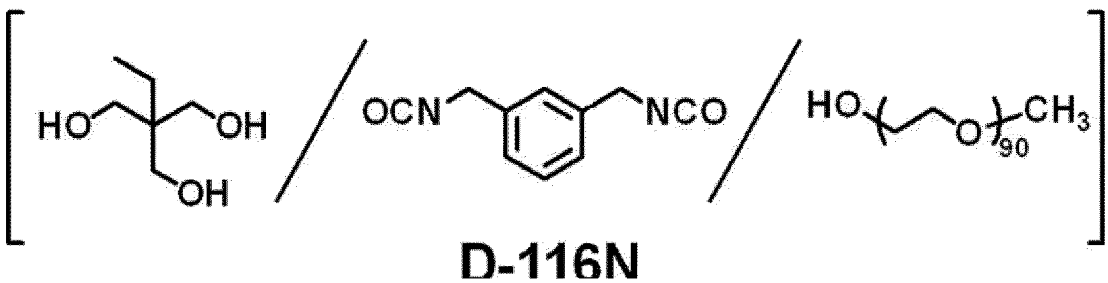

**D-116N**

- Preparation of water phase component -

As a water phase component, 47.2 g of distilled water was prepared.

- Microcapsule forming step -

A water phase component was added to and mixed with the oil phase component, and the obtained mixture was emulsified at 12,000 rpm for 16 minutes using a homogenizer to obtain an emulsion.

16.8 g of distilled water was added to the obtained emulsion, and the obtained liquid was stirred at room

temperature for 10 minutes. Next, the stirred liquid was heated to 45°C and stirred for 4 hours in a state where the liquid temperature thereof was maintained at 45°C to distill off ethyl acetate from the liquid. Next, 5.12 g of a 10 mass% aqueous solution of 1,8-diazabicyclo[5.4.0]undeca-7-ene-octylate (U-CAT SA102, manufactured by San-Apro Ltd.) was added thereto, and the solution was stirred at room temperature for 30 minutes and allowed to stand at 45°C for 24 hours. The concentration of solid contents was adjusted to 20% by mass using distilled water, thereby obtaining a microgel solution 2. The volume average particle diameter of the microgel in the microgel solution 2 was 165 nm after the measurement by a laser diffraction/scattering-type particle size distribution analyzer LA-920 (manufactured by Horiba, Ltd.).

(Image recording layer coating solution 3)

The following components were mixed to prepare an image recording layer coating solution 3.

· Infrared absorbing agent (IR-1): 0.0203 parts by mass
· Infrared absorbing agent (IR-2): 0.0068 parts by mass
· Color developing agent (S-2): 0.0120 parts by mass
· Color developing agent (S-3): 0.0300 parts by mass
· Electron-accepting polymerization initiator (Int-1): 0.0981 parts by mass
· Electron-donating polymerization initiator (TPB): 0.0270 parts by mass
· Polymerizable compound (M-2): 0.3536 parts by mass
· Tricresyl phosphate: 0.0125 parts by mass
· Anionic surfactant (A-1): 0.0162 parts by mass
· PIONIN A-41-C (manufactured by Takemoto Oil & Fat Co., Ltd., 70% methanol solution): 0.0081 parts by mass
· Fluorine-based surfactant (W-1): 0.0042 parts by mass
· 2-Butanone: 5.3155 parts by mass
· 1-Methoxy-2-propanol: 2.8825 parts by mass
· Methanol: 2.3391 parts by mass
· Microgel solution 2: 2.8779 parts by mass

[Formation of protective layer]

The image recording layer of the aluminum support on which the image recording layer had been formed was bar-coated with the protective layer coating solution 1 and dried in an oven at 120°C for 60 seconds to form a protective layer having a dry coating amount of 0.80 g/$m^2$.

(Protective layer coating solution 1)

The following components were mixed to prepare a protective layer coating solution 1.

· Water: 1.0161 parts by mass
· METOLOSE SM04: 0.0600 parts by mass
· FS-102 (17% aqueous dispersion liquid): 0.1177 parts by mass
· RAPISOL A-80 (80% aqueous solution): 0.0063 parts by mass

[Evaluation method]

<Oil-based cleaner printing durability>

Each lithographic printing plate precursor obtained in the examples and the comparative examples was exposed by Luxel PLATESETTER T-6000III (manufactured by Fujifilm Corporation) equipped with an infrared semiconductor laser under conditions of an external drum rotation speed of 1,000 rpm, a laser output of 70%, and a resolution of 2,400 dpi. The exposed image had a solid image and a 50% halftone dot chart of a 20 μm dot frequency modulation (FM) screen.
The obtained exposed lithographic printing plate precursor was attached to the plate cylinder of a printing press LITHRONE26 (manufactured by KOMORI Corporation) without performing a development treatment. Dampening water and ink were supplied by a standard automatic printing start method for LITHRONE26 using dampening water, in which the volume ratio of Ecolity-2 (manufactured by Fujifilm Corporation) to tap water was 2:98, and Values-G (N) black ink (manufactured by DIC Corporation) to perform on-press development, and then printing was performed on Tokubishi Art (76.5 kg) paper at a printing speed of 10,000 sheets per hour. As the number of printed sheets increased, the image recording layer was gradually abraded, and thus the ink density on the printed material decreased. The number of printed

sheets at a time at which visual recognition that the density of the solid image began to decrease was made was defined as the standard number of printed sheets.

Next, the number of printed sheets at the time at which visual recognition that the density of the solid image began to decrease was made was acquired by the same method as described above except that a step of wiping the plate surface with a cleaner (manufactured by FUJIFILM Corporation, multi-cleaner) was provided every time 5,000 sheets were printed. The obtained number of printed sheets is defined as the evaluated number of printed sheets.

Next, an index value acquired by Equation (X) was calculated using the standard number of printed sheets and the evaluated number of printed sheets, and the evaluation was performed according to the following standard.

Equation (X): index value = (standard number of printed sheets - evaluated number of printed sheets)/standard number of printed sheets

It can be said that as the index value increases, a change in printing durability decreases even in a case where the step of wiping the plate surface with a cleaner was added, and thus the oil-based cleaner printing durability is excellent.

- Evaluation standards -

6: The index value was 98% or greater and less than 100%.
5: The index value was 95% or greater and less than 98%.
4: The index value was 80% or greater and less than 95%.
3: The index value was 60% or greater and less than 80%.
2: The index value was 40% or greater and less than 60%.
1: The index value was less than 40%.

In Table 3, the columns of "first specific recesses (pc/$mm^2$)" denote the density of the first specific recesses (pc/$mm^2$).

In Table 3, the columns of "second specific recesses (pc/$mm^2$)" denote the density of the second specific recesses (pc/$mm^2$).

In Table 3, the columns of "area ratio (%) of specific projections" denote the area ratio (%) of the specific projections.

[Table 3]

| | Formulation | Shape | | | | | Large-diameter pores | | Small-diameter pores | | Evaluation |
|---|---|---|---|---|---|---|---|---|---|---|---|
| | | First specific recesses (pc/mm$^2$) | Second specific recesses (pc/mm$^2$) | Area ratio of specific projections (%) | $\Delta S$ (%) | Ra ($\mu m$) | Surface layer average diameter (nm) | Depth (nm) | Internal average diameter (nm) | Depth (nm) | Oil-based cleaner printing durability |
| Example 1 | A | 4040 | 5600 | 18 | 41 | 0.46 | 28 | 100 | 10 | 1200 | 3 |
| Example 2 | A | 5200 | 5200 | 15 | 37 | 0.45 | 28 | 100 | 10 | 1200 | 3 |
| Example 3 | A | 6700 | 4700 | 17 | 44 | 0.42 | 28 | 100 | 10 | 1200 | 4 |
| Example 4 | A | 7800 | 4300 | 13 | 39 | 0.39 | 28 | 100 | 10 | 1200 | 4 |
| Example 5 | A | 8200 | 3800 | 11 | 38 | 0.35 | 28 | 100 | 10 | 1200 | 5 |
| Example 6 | A | 10500 | 3500 | 8 | 42 | 0.32 | 28 | 100 | 10 | 1200 | 6 |
| Example 7 | A | 6700 | 4900 | 20 | 39 | 0.46 | 28 | 100 | 10 | 1200 | 3 |
| Example 8 | A | 6700 | 4300 | 11 | 44 | 0.43 | 28 | 100 | 10 | 1200 | 4 |
| Example 9 | A | 6700 | 5100 | 6 | 46 | 0.39 | 28 | 100 | 10 | 1200 | 5 |
| Example 10 | A | 6700 | 4700 | 3 | 43 | 0.41 | 28 | 100 | 10 | 1200 | 5 |
| Example 11 | A | 5200 | 6200 | 6 | 42 | 0.35 | 28 | 100 | 10 | 1200 | 5 |
| Example 12 | A | 6000 | 11000 | 0.4 | 57 | 0.25 | 28 | 100 | 10 | 1200 | 6 |
| Example 13 | A | 5200 | 10200 | 0.6 | 55 | 0.23 | 28 | 100 | 10 | 1200 | 6 |
| Example 14 | A | 5800 | 9800 | 0.2 | 60 | 0.22 | 28 | 100 | 10 | 1200 | 6 |
| Example 15 | A | 5200 | 6200 | 6 | 46 | 0.35 | 28 | 100 | 10 | 1200 | 6 |
| Example 16 | A | 5200 | 6200 | 6 | 43 | 0.35 | 28 | 100 | 10 | 1200 | 5 |
| Example 17 | A | 5200 | 6200 | 6 | 25 | 0.35 | 28 | 100 | 10 | 1200 | 5 |
| Example 18 | A | 5200 | 6200 | 6 | 20 | 0.35 | 28 | 100 | 10 | 1200 | 4 |
| Example 19 | A | 5200 | 6200 | 6 | 17 | 0.35 | 28 | 100 | 10 | 1200 | 3 |
| Example 20 | A | 4000 | 5600 | 9 | 46 | 0.41 | 28 | 100 | 10 | 1200 | 5 |
| Example 21 | A | 4000 | 5600 | 9 | 43 | 0.41 | 28 | 100 | 10 | 1200 | 4 |
| Example 22 | A | 4000 | 5600 | 9 | 25 | 0.41 | 28 | 100 | 10 | 1200 | 4 |
| Example 23 | A | 4000 | 5600 | 9 | 20 | 0.41 | 28 | 100 | 10 | 1200 | 3 |

(continued)

| | Formulation | Shape | | | | | Large-diameter pores | | Small-diameter pores | | Evaluation |
|---|---|---|---|---|---|---|---|---|---|---|---|
| | | First specific recesses ($pc/mm^2$) | Second specific recesses ($pc/mm^2$) | Area ratio of specific projections (%) | $\Delta S$ (%) | Ra ($\mu m$) | Surface layer average diameter (nm) | Depth (nm) | Internal average diameter (nm) | Depth (nm) | Oil-based cleaner printing durability |
| Example 24 | B | 5200 | 6200 | 6 | 46 | 0.35 | 28 | 100 | 10 | 1200 | 6 |
| Example 25 | B | 5200 | 6200 | 6 | 20 | 0.35 | 28 | 100 | 10 | 1200 | 4 |
| Example 26 | B | 4000 | 5600 | 9 | 46 | 0.41 | 28 | 100 | 10 | 1200 | 5 |
| Example 27 | B | 4000 | 5600 | 9 | 20 | 0.41 | 28 | 100 | 10 | 1200 | 3 |
| Example 28 | C | 5200 | 6200 | 6 | 46 | 0.35 | 28 | 100 | 10 | 1200 | 6 |
| Example 29 | C | 5200 | 6200 | 6 | 20 | 0.35 | 28 | 100 | 10 | 1200 | 4 |
| Example 30 | C | 4000 | 5600 | 9 | 46 | 0.41 | 28 | 100 | 10 | 1200 | 5 |
| Example 31 | C | 4000 | 5600 | 9 | 20 | 0.41 | 28 | 100 | 10 | 1200 | 3 |
| Example 32 | D | 5200 | 6200 | 6 | 46 | 0.35 | 28 | 100 | 10 | 1200 | 6 |
| Example 33 | D | 5200 | 6200 | 6 | 20 | 0.35 | 28 | 100 | 10 | 1200 | 4 |
| Example 34 | D | 4000 | 5600 | 9 | 46 | 0.41 | 28 | 100 | 10 | 1200 | 5 |
| Example 35 | D | 4000 | 5600 | 9 | 20 | 0.41 | 28 | 100 | 10 | 1200 | 3 |
| Comparative Example 1 | A | 3700 | 4000 | 21 | 41 | 0.44 | 28 | 100 | 10 | 1200 | 2 |
| Comparative Example 2 | A | 2800 | 4000 | 22 | 38 | 0.41 | 28 | 100 | 10 | 1200 | 1 |
| Comparative Example 3 | A | 3900 | 3200 | 21 | 44 | 0.38 | 28 | 100 | 10 | 1200 | 2 |
| Comparative Example 4 | A | 3900 | 2500 | 28 | 35 | 0.43 | 28 | 100 | 10 | 1200 | 1 |

As listed in Table 3, it was confirmed that desired effects were obtained in a case where the lithographic printing plate precursor of the present invention was used.

Based on the comparison of Examples 1 to 5, it was confirmed that the effects were more excellent in a case where the number of the first specific recesses was 6,000 pc/mm$^2$ or greater (preferably in a case where the number of the first specific recesses was 8,000 pc/mm$^2$ or greater).

Based on the comparison between Examples 5 and 6, it was confirmed that the effects were more excellent in a case where the area ratio of the specific projections was 10% or less (preferably, in a case where the area ratio thereof was 8% or less).

Based on the comparison between Examples 7 and 8, it was confirmed that the effects were more excellent in a case where the area ratio of the specific projections was 13% or less. Further, based on the comparison between Example 8 and Examples 9 and 10, it was confirmed that the effects were more excellent in a case where the area ratio of the specific projections was 10% or less. Further, based on the comparison between Examples 9 and 10 and Example 12, it was confirmed that the effects were more excellent in a case where the area ratio of the specific projections was less than 3%.

Further, the oil-based cleaner printing durability was evaluated as "5" in both Examples 9 and 11. In Example 11, the number of the first specific recesses was less than 6,000 pc/mm$^2$, but the number of the second specific projections was 6,000 pc/mm2 or greater, and thus the evaluation results of Example 9 and Example 11 were the same as each other. That is, it was confirmed that the effects were more excellent in a case where the number of the second specific projections was 6,000 pc/mm$^2$ or greater.

From Examples 12 to 14, it was confirmed that the most excellent effects were obtained in a case where the area ratio of the specific projections was 10% or less, the number of the second specific recesses was 6,000 pc/mm$^2$ or greater, and the surface area ratio $\Delta S$ was 45% or greater.

Based on Examples 15 to 19, it was confirmed that the effects were more excellent in a case where the area ratio of the specific projections was 10% or less and the surface area ratio $\Delta S$ was 20% or greater. In addition, it was confirmed that the effects were more excellent in a case where the area ratio of the specific projections was 10% or less and the surface area ratio $\Delta S$ was 45% or greater.

Based on the comparison between Examples 18 and 23, it was confirmed that the effects were more excellent in a case where the area ratio of the specific projections was 7% or less and the surface area ratio $\Delta S$ was 20% or greater.

Based on the comparison between Example 15 and Example 20, it was confirmed that the effects were more excellent in a case where the area ratio of the specific projections was 7% or less and the surface area ratio $\Delta S$ was 45% or greater.

<Examples 36 to 39>

Each aluminum support was prepared by the same procedure as in Example 1 except that the liquid temperature of the electrolytic solution, the peak current value of the alternating current waveform as the current density, the sum of the electric quantity, the conditions of the anodization treatment, and the conditions of the pore widening treatment in <electrochemical roughening treatment> in Example 1 were changed as listed in Table 4.

[Table 4]

| | Conditions for hydrochloric acid electrolysis | | | | First anodization treatment | | | | Pore widening treatment | | Second anodization treatment | | | |
|---|---|---|---|---|---|---|---|---|---|---|---|---|---|---|
| | Temperature of hydrochloric acid liquid (°C) | Concentration of sulfuric acid (g/L) | Peak current (A/dm$^2$) | Electric quantity for anode (c/dm$^2$) | Electrolytic solution (g/l) | Temperature (°C) | Current density (A/dm$^2$) | Coated film amount (g/m$^2$) | Temperature (°C) | Time (sec) | Electrolytic solution (g/l) | Temperature (°C) | Current density (A/dm$^2$) | Coated film amount (g/m$^2$) |
| Example 36 | 25 | 1 | 7 | 250 | 150 | 50 | 15 | 0.2 | 30 | 5 | 150 | 50 | 30 | 3.4 |
| Example 37 | 25 | 1 | 5 | 250 | 150 | 50 | 15 | 0.2 | 30 | 5 | 150 | 50 | 30 | 3.4 |
| Example 38 | 20 | 1 | 5 | 250 | 150 | 50 | 15 | 0.2 | 30 | 5 | 150 | 50 | 30 | 3.4 |
| Example 39 | 17 | 0.2 | 35 | 300 | 150 | 50 | 15 | 0.2 | 30 | 5 | 150 | 50 | 30 | 3.4 |

The density of the second specific recesses, the density of the specific projections, the area ratio of the specific projections, the surface area ratio ΔS, and the value of the surface roughness Ra in the surface of the anodized film on a side opposite to the side of the aluminum plate in the prepared aluminum support were measured by the above-described methods. These results are listed in Table 5.

In addition, the average diameter (surface layer average diameter) of large-diameter pores in the surface of the anodized film having micropores, the average diameter (internal average diameter) of small-diameter pores at communication positions, and the depths of the large-diameter pores and the small-diameter pores in the prepared aluminum support were measured by the above-described methods. These results are listed in Table 5.

Each lithographic printing plate precursor was prepared by performing the procedures in the sections of "formation of undercoat layer" and "formation of image recording layer" using the obtained aluminum support, and the evaluation of "oil-based cleaner printing durability" was performed. The results are listed in Table 5.

[Table 5]

| | | | | | Large-diameter pores | | Small-diameter pores | | Evaluation |
|---|---|---|---|---|---|---|---|---|---|
| | Second specific recesses (pc/mm$^2$) | Area ratio of specific projections (%) | ΔS (%) | Ra (μm) | Surface layer average diameter (nm) | Depth (nm) | Internal average diameter (nm) | Depth (nm) | Oil-based cleaner printing durability |
| Example 36 | 5700 | 19 | 39 | 0.39 | 28 | 100 | 10 | 1200 | 3 |
| Example 37 | 5800 | 12 | 40 | 0.4 | 28 | 100 | 10 | 1200 | 4 |
| Example 38 | 5400 | 8 | 37 | 0.41 | 28 | 100 | 10 | 1200 | 5 |
| Example 39 | 7300 | 2 | 44 | 0.28 | 28 | 100 | 10 | 1200 | 6 |

As listed in Table 5, it was confirmed that desired effects were obtained in a case where the lithographic printing plate precursor of the present invention was used.

Based on the comparison between Examples 15 and 16, it was confirmed that the effects were more excellent in a case where the area ratio of the specific projections was 13% or less. Further, based on the comparison between Examples 16 and 17, it was confirmed that the effects were more excellent in a case where the area ratio of the specific projections was 10% or less. Further, based on the comparison between Examples 17 and 18, it was confirmed that the effects were more excellent in a case where the area ratio of the specific projections was less than 3%.

Explanation of References

ta: anodic reaction time
tc: cathodic reaction time
tp: time until current value reaches peak from zero
Ia: peak current on anode cycle side
Ic: peak current on cathode cycle side
10: lithographic printing plate precursor
12a, 12b: aluminum support
14: undercoat layer
16: image recording layer
18: aluminum plate
20a, 20b: anodized film
22a, 22b: micropore
24: large-diameter pore
26: small-diameter pore

50: main electrolytic cell
51: AC power source
52: radial drum roller
53a, 53b: main pole
54: electrolytic solution supply port
55: electrolytic solution
56: auxiliary anode
60: auxiliary anode cell
W: aluminum plate
610: anodization treatment device
612: power supply tank
614: electrolytic treatment tank
616: aluminum plate
618, 626: electrolytic solution
620: power supply electrode
622, 628: roller
624: nip roller
630: electrolytic electrode
632: cell wall
634: DC power source

## Claims

**1.** A lithographic printing plate precursor comprising:

an aluminum support; and
an image recording layer disposed on the aluminum support,
wherein the aluminum support includes an aluminum plate and an anodized aluminum film disposed on the aluminum plate,
the image recording layer is disposed on the aluminum support on a side of the anodized film,
a density of recesses with a depth of 0.40 μm or greater from an average level, which is obtained by measuring a surface of the aluminum support on a side of the image recording layer in an area of 400 μm × 400 μm using a non-contact three-dimensional roughness meter, is 8,000 pc/mm$^2$ or greater.

**2.** The lithographic printing plate precursor according to claim 1,
wherein an area ratio of projections with a height of 0.80 μm or greater from an average level, which is obtained by measuring the surface of the aluminum support on the side of the image recording layer in an area of 400 μm × 400 μm using a non-contact three-dimensional roughness meter, is 20% or less.

**3.** The lithographic printing plate precursor according to any one of claims 1 to 2,
wherein a density of recesses with a depth of 0.20 μm or greater from the average level, which is obtained by measuring the surface of the aluminum support on the side of the image recording layer in an area of 400 μm × 400 μm using a non-contact three-dimensional roughness meter, is 6,000 pc/mm$^2$ or greater.

**4.** The lithographic printing plate precursor according to any one of claims 1 to 3,
wherein a surface area ratio ΔS calculated according to Equation (1), from a geometrically measured area S0 and an actual area Sx acquired by an approximate three-point method from three-dimensional data obtained by measuring 512 × 512 points with an area of 25 μm × 25 μm on the surface of the aluminum support on the side of the image recording layer using an atomic force microscope, is 20% or greater,

$$\Delta S = (Sx - S0)/S0 \times 100\ (\%) \cdots (1).$$

**5.** The lithographic printing plate precursor according to claim 4,
wherein the surface area ratio ΔS is 45% or greater.

**6.** The lithographic printing plate precursor according to any one of claims 1 to 5,

wherein the anodized film has micropores,
the micropores are formed of large-diameter pores extending to a position at a depth of 10 to 1,000 nm from the surface of the anodized film and small-diameter pores communicating with bottom portions of the large-diameter pores and extending to a position at a depth of 20 to 2,000 nm from communication positions,
an average diameter of the large-diameter pores in the surface of the anodized film is in a range of 15 to 60 nm, and an average diameter of the small-diameter pores at the communication positions is greater than the average diameter of the large-diameter pores.

**7.** The lithographic printing plate precursor according to any one of claims 1 to 6, wherein the area ratio of the projections with a height of 0.80 μm or greater from the average level is 10% or less.

**8.** The lithographic printing plate precursor according to any one of claims 1 to 7, wherein the area ratio of the projections with a height of 0.80 μm or greater from the average level is 7% or less.

**9.** A method of producing a lithographic printing plate comprising:

an exposing step of imagewise-exposing the lithographic printing plate precursor according to any one of claims 1 to 8 to form an exposed portion and an unexposed portion; and
a removing step of removing the unexposed portion of the imagewise-exposed lithographic printing plate precursor.

**10.** A printing method comprising:

an exposing step of imagewise-exposing the lithographic printing plate precursor according to any one of claims 1 to 8 to form an exposed portion and an unexposed portion; and
a printing step of supplying at least one of a printing ink or dampening water to remove the unexposed portion of the imagewise-exposed lithographic printing plate precursor on a printing press, and performing printing.

**Patentansprüche**

**1.** Lithographischer Druckplattenvorläufer, umfassend:

einen Aluminiumträger; und
eine Bildaufzeichnungsschicht, die auf dem Aluminiumträger angeordnet ist,
wobei der Aluminiumträger eine Aluminiumplatte und einen eloxierten Aluminiumfilm, der auf der Aluminiumplatte angeordnet ist, enthält,
die Bildaufzeichnungsschicht auf dem Aluminiumträger auf einer Seite des eloxierten Films angeordnet ist,
eine Dichte von Vertiefungen mit einer Tiefe von 0,40 μm oder mehr von einem durchschnittlichen Niveau, das durch Messen einer Oberfläche des Aluminiumträgers auf einer Seite der Bildaufzeichnungsschicht in einer Fläche von 400 μm × 400 μm unter Verwendung eines kontaktlosen dreidimensionalen Rauheitsmessers erhalten wird, 8.000 pc/mm$^2$ oder mehr beträgt.

**2.** Lithographischer Druckplattenvorläufer nach Anspruch 1,
wobei ein Flächenverhältnis von Vorsprüngen mit einer Höhe von 0,80 μm oder mehr von einem durchschnittlichen Niveau, das durch Messen der Oberfläche des Aluminiumträgers auf der Seite der Bildaufzeichnungsschicht in einer Fläche von 400 μm × 400 μm unter Verwendung eines kontaktlosen dreidimensionalen Rauheitsmessers erhalten wird, 20 % oder weniger beträgt.

**3.** Lithographischer Druckplattenvorläufer nach einem der Ansprüche 1 bis 2, wobei eine Dichte von Vertiefungen mit einer Tiefe von 0,20 μm oder mehr von dem durchschnittlichen Niveau, das durch Messen der Oberfläche des Aluminiumträgers auf der Seite der Bildaufzeichnungsschicht in einer Fläche von 400 μm × 400 μm unter Verwendung eines kontaktlosen dreidimensionalen Rauheitsmessers erhalten wird, 6.000 pc/mm$^2$ oder mehr beträgt.

**4.** Lithographischer Druckplattenvorläufer nach einem der Ansprüche 1 bis 3,
wobei ein Oberflächenverhältnis ΔS, das gemäß Gleichung (1) berechnet wird, aus einer geometrisch gemessenen

Fläche S0 und einer tatsächlichen Fläche Sx, die durch ein Drei-Punkt-Näherungsverfahren aus dreidimensionalen Daten, die durch Messen von 512 × 512 Punkten mit einer Fläche von 25 μm × 25 μm auf der Oberfläche des Aluminiumträgers auf der Seite der Bildaufzeichnungsschicht unter Verwendung eines Rasterkraftmikroskops erhalten werden, erfasst wird, 20 % oder mehr beträgt,

$$\Delta S = (Sx - S0)/S0 \times 100\ (\%) \cdots (1).$$

**5.** Lithographischer Druckplattenvorläufer nach Anspruch 4,
wobei das Oberflächenverhältnis ΔS 45 % oder mehr beträgt.

**6.** Lithographischer Druckplattenvorläufer nach einem der Ansprüche 1 bis 5,

wobei der eloxierte Film Mikroporen aufweist,
die Mikroporen aus Poren mit großem Durchmesser, die sich zu einer Position in einer Tiefe von 10 bis 1.000 nm von der Oberfläche des eloxierten Films erstrecken, und Poren mit kleinem Durchmesser, die mit Bodenabschnitten der Poren mit großem Durchmesser kommunizieren und sich zu einer Position in einer Tiefe von 20 bis 2.000 nm von Kommunikationspositionen erstrecken, gebildet sind,
ein durchschnittlicher Durchmesser der Poren mit großem Durchmesser in der Oberfläche des eloxierten Films in einem Bereich von 15 bis 60 nm liegt, und
ein durchschnittlicher Durchmesser der Poren mit kleinem Durchmesser an den Kommunikationspositionen größer als der durchschnittliche Durchmesser der Poren mit großem Durchmesser ist.

**7.** Lithographischer Druckplattenvorläufer nach einem der Ansprüche 1 bis 6, wobei das Flächenverhältnis der Vorsprünge mit einer Höhe von 0,80 μm oder mehr von dem durchschnittlichen Niveau 10 % oder weniger beträgt.

**8.** Lithographischer Druckplattenvorläufer nach einem der Ansprüche 1 bis 7, wobei das Flächenverhältnis der Vorsprünge mit einer Höhe von 0,80 μm oder mehr von dem durchschnittlichen Niveau 7 % oder weniger beträgt.

**9.** Verfahren des Produzierens einer lithographischen Druckplatte, umfassend:

einen Belichtungsschritt des bildweisen Belichtens des lithographischen Druckplattenvorläufers nach einem der Ansprüche 1 bis 8, um einen belichteten Abschnitt und einen nicht belichteten Abschnitt zu bilden; und
einen Entfernungsschritt des Entfernens des nicht belichteten Abschnitts des bildweise belichteten lithographischen Druckplattenvorläufers.

**10.** Druckverfahren, umfassend:

einen Belichtungsschritt des bildweisen Belichtens des lithographischen Druckplattenvorläufers nach einem der Ansprüche 1 bis 8, um einen belichteten Abschnitt und einen nicht belichteten Abschnitt zu bilden; und
einen Druckschritt des Zuführens von mindestens einem von einer Druckfarbe und
Feuchtwasser, um den nicht belichteten Abschnitt des bildweise belichteten lithographischen Druckplattenvorläufers auf einer Druckmaschine zu entfernen, und des Durchführens von Drucken.

## Revendications

**1.** Précurseur de plaque d'impression lithographique comprenant :

un support en aluminium ; et
une couche d'enregistrement d'images disposée sur le support en aluminium,
dans lequel le support en aluminium comprend une plaque en aluminium et un film en aluminium anodisé disposé sur la plaque en aluminium,
la couche d'enregistrement d'images est disposée sur le support en aluminium sur un côté du film anodisé,
une densité de creux avec une profondeur de 0,40 μm ou plus à partir d'un niveau moyen, qui est obtenue en mesurant une surface du support en aluminium sur un côté de la couche d'enregistrement d'images dans une zone de 400 μm × 400 μm en utilisant un appareil de mesure de rugosité tridimensionnelle sans contact, est de 8

000 pc/mm$^2$ ou plus.

2. Précurseur de plaque d'impression lithographique selon la revendication 1,
dans lequel un rapport de surface de projections avec une hauteur de 0,80 $\mu$m ou plus à partir d'un niveau moyen, qui est obtenu en mesurant la surface du support en aluminium sur le côté de la couche d'enregistrement d'images dans une zone de 400 $\mu$m $\times$ 400 $\mu$m en utilisant un appareil de mesure de rugosité tridimensionnelle sans contact, est de 20 % ou moins.

3. Précurseur de plaque d'impression lithographique selon l'une quelconque des revendications 1 à 2,
dans lequel une densité de creux avec une profondeur de 0,20 $\mu$m ou plus à partir du niveau moyen, qui est obtenue en mesurant la surface du support en aluminium sur le côté de la couche d'enregistrement d'images dans une zone de 400 $\mu$m $\times$ 400 $\mu$m en utilisant un appareil de mesure de rugosité tridimensionnelle sans contact, est de 6 000 pc/mm$^2$ ou plus.

4. Précurseur de plaque d'impression lithographique selon l'une quelconque des revendications 1 à 3,
dans lequel un rapport de surface ΔS calculé selon l'équation (1), à partir d'une surface mesurée géométriquement S0 et d'une surface réelle Sx acquise par une méthode approximative à trois points à partir de données tridimensionnelles obtenues en mesurant 512 $\times$ 512 points avec une surface de 25 $\mu$m $\times$ 25 $\mu$m sur la surface du support en aluminium sur le côté de la couche d'enregistrement d'images en utilisant un microscope à force atomique, est de 20 % ou plus,

$$\Delta S = (Sx - S0)/S0 \times 100\ (\%) \cdots (1).$$

5. Précurseur de plaque d'impression lithographique selon la revendication 4, dans lequel le rapport de surface ΔS est de 45 % ou plus.

6. Précurseur de plaque d'impression lithographique selon l'une quelconque des revendications 1 à 5,

dans lequel le film anodisé a des micropores,
les micropores sont formés de pores de grand diamètre s'étendant jusqu'à une position à une profondeur de 10 à 1 000 nm à partir de la surface du film anodisé et de pores de petit diamètre communiquant avec des parties inférieures des pores de grand diamètre et s'étendant jusqu'à une position à une profondeur de 20 à 2 000 nm à partir de positions de communication,
un diamètre moyen des pores de grand diamètre dans la surface du film anodisé est dans une plage de 15 à 60 nm, et
un diamètre moyen des pores de petit diamètre aux positions de communication est supérieur au diamètre moyen des pores de grand diamètre.

7. Précurseur de plaque d'impression lithographique selon l'une quelconque des revendications 1 à 6, dans lequel le rapport de surface des projections avec une hauteur de 0,80 $\mu$m ou plus à partir du niveau moyen est de 10 % ou moins.

8. Précurseur de plaque d'impression lithographique selon l'une quelconque des revendications 1 à 7, dans lequel le rapport de surface des projections avec une hauteur de 0,80 $\mu$m ou plus à partir du niveau moyen est de 7 % ou moins.

9. Procédé de production d'une plaque d'impression lithographique comprenant :

une étape d'exposition consistant à exposer image par image le précurseur de plaque d'impression lithographique selon l'une quelconque des revendications 1 à 8 pour former une partie exposée et une partie non exposée ; et
une étape de retrait consistant à retirer la partie non exposée du précurseur de plaque d'impression lithographique exposé image par image.

10. Procédé d'impression comprenant :

une étape d'exposition consistant à exposer image par image le précurseur de plaque d'impression lithographique selon l'une quelconque des revendications 1 à 8 pour former une partie exposée et une partie non exposée ; et
une étape d'impression consistant à fournir au moins l'une d'une encre d'impression ou d'eau de mouillage pour retirer la partie non exposée du précurseur de plaque d'impression lithographique exposé image par image sur une presse d'impression, et à effectuer l'impression.

FIG. 1

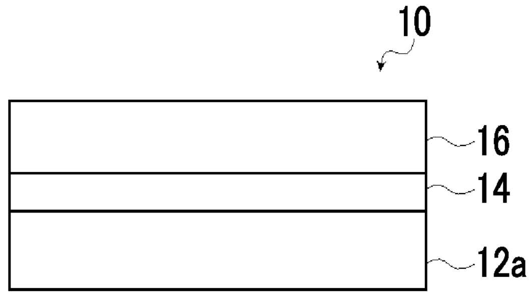


FIG. 2

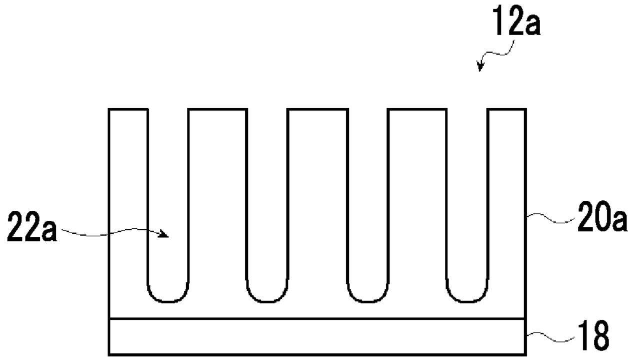


FIG. 3

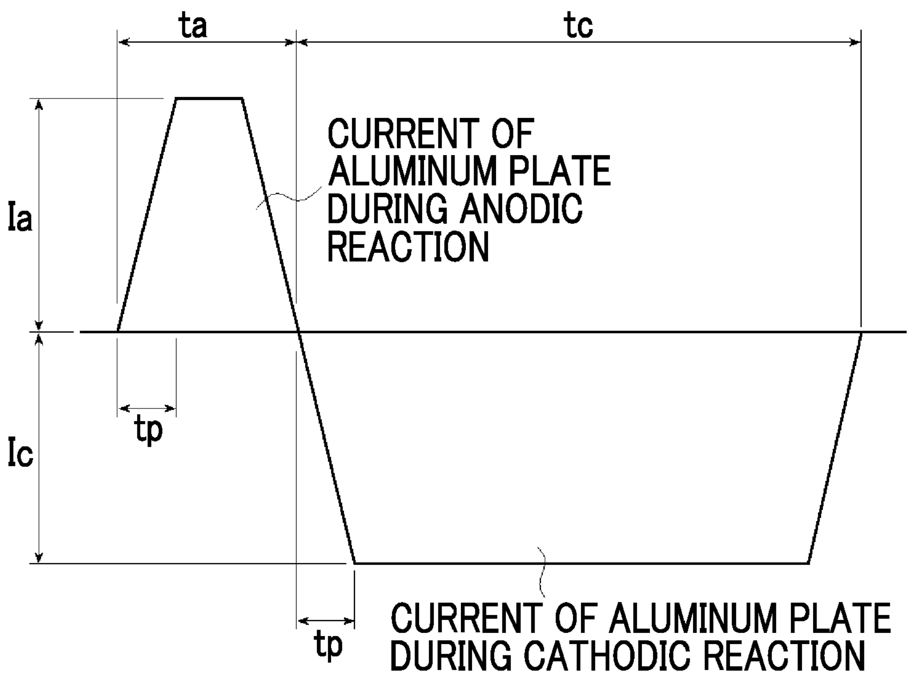

FIG. 4

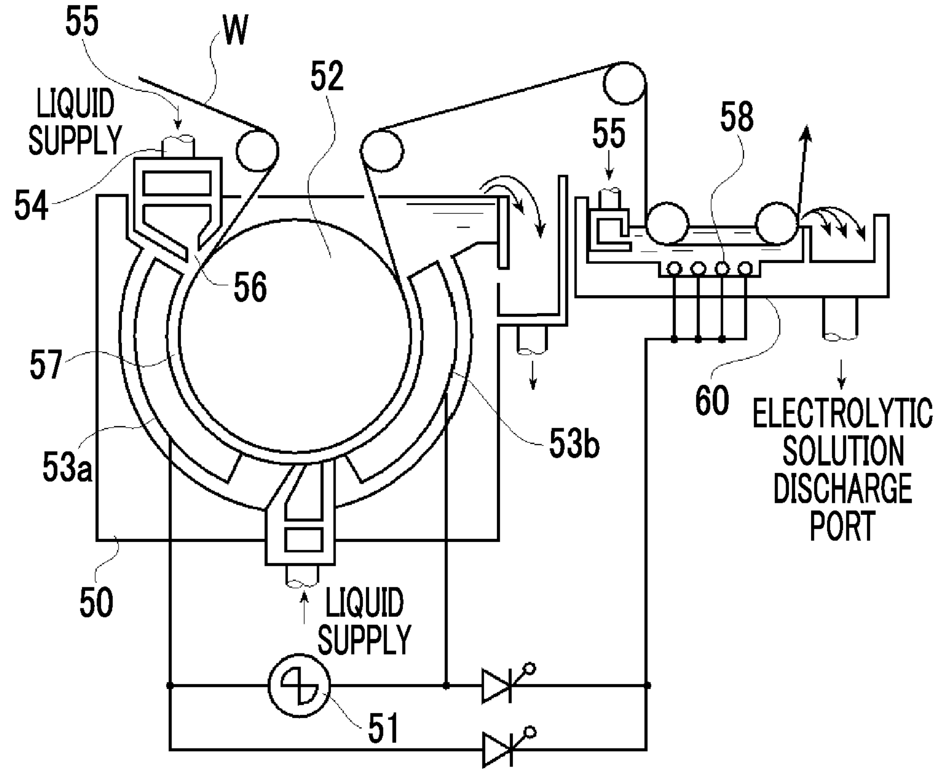


FIG. 5

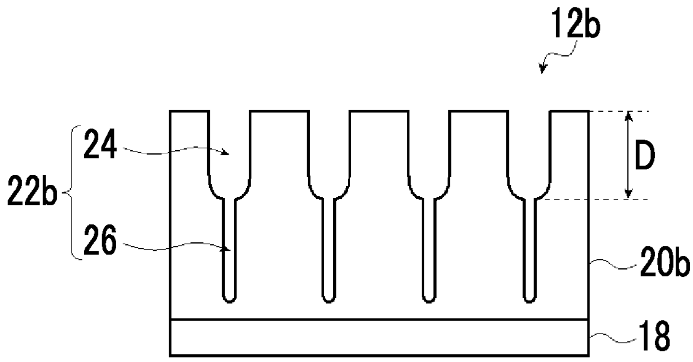


FIG. 6

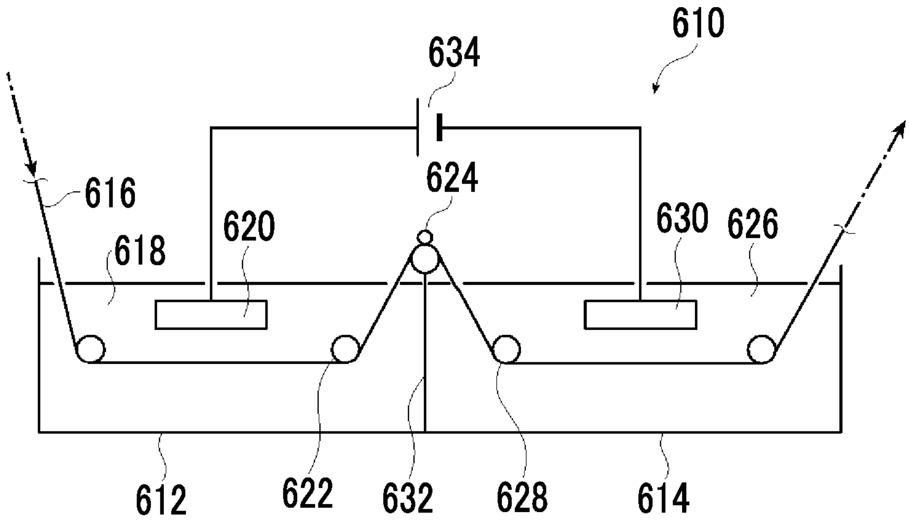

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019087516 A
- EP 1577115 A
- US 3276868 A
- US 4153461 A
- US 4689272 A
- JP 2001312068 A
- JP 2008195018 A
- JP 2009255434 A
- JP 48041708 B
- JP 2012187907 A
- JP 6135175 A
- JP H6135175 A
- JP 50040047 B
- JP 2005254638 A
- US 2714066 A
- US 3181461 A


### Non-patent literature cited in the description


- Dye Handbook. 1970